(19) Europäisches Patentamt
European Patent Office
Office européen des brevets

(11) EP 2 687 370 B1

(12) **EUROPEAN PATENT SPECIFICATION**

(45) Date of publication and mention of the grant of the patent:
**29.04.2020 Bulletin 2020/18**

(21) Application number: **12761435.2**

(22) Date of filing: **19.03.2012**

(51) Int Cl.:
***B32B 15/09*** (2006.01) ***B32B 27/36*** (2006.01)
***B32B 27/06*** (2006.01)

(86) International application number:
**PCT/KR2012/001941**

(87) International publication number:
**WO 2012/128518 (27.09.2012 Gazette 2012/39)**

(54) **POLYESTER-BASED DEPOSITION FILM**

ABSCHEIDUNGSFILM AUF POLYESTERBASIS

FILM À BASE DE POLYESTER DESTINÉ À ÊTRE DÉPOSÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.03.2011 KR 20110024434**
**18.03.2011 KR 20110024475**

(43) Date of publication of application:
**22.01.2014 Bulletin 2014/04**

(73) Proprietor: **Kolon Industries, Inc.**
**Seoul 07793 (KR)**

(72) Inventors:
- **KIM, Yun Jo**
  **Gumi-si**
  **Gyeongbuk 730-764 (KR)**
- **KWON, Il Chon**
  **Daegu 706-929 (KR)**
- **KIM, Dong Jin**
  **Gumi-si**
  **Gyeongbuk 730-799 (KR)**
- **KIM, Si Min**
  **Daegu 704-140 (KR)**

(74) Representative: **Ter Meer Steinmeister & Partner Patentanwälte mbB**
**Nymphenburger Straße 4**
**80335 München (DE)**

(56) References cited:
**EP-A2- 0 959 447**
**JP-A- 2003 225 962**
**KR-A- 20020 089 584**
**KR-A- 20060 078 530**
**KR-A- 20090 061 574**
**US-A- 5 190 609**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 687 370 B1

## Description

[Technical Field]

The present invention relates to a metalizing film containing a polyester-based film layer having heat-shrinking characteristics, and use of the deposition film used as a film label capable of replacing a paper label attached to a glass bottle.

[Background Art]

In consideration of environmental requirements and economical efficiency, a polyethylene terephthalate (PET) bottle or a glass bottle has been collected and then recycled. At the time of recycling the PET or glass bottle, a label on which a product name, ingredients, other figures, or the like, are printed and attached to the PET or glass bottle except for a body of the PET or glass bottle should be separated and removed. In the case of a paper label that has been mainly used up to now, the paper label has been removed using industrial water. More specifically, the collected PET bottle or glass bottle is immersed in industrial water containing caustic soda at about 80°C, thereby removing the label. Therefore, environmental waste water is generated in recycling an empty bottle, which causing environmental regulations to become stricter.

Therefore, a demand for a label made of a film material rather than the paper label has increased.

Meanwhile, as an example of a film capable of being used as a label, there is a poly vinyl chloride-based film, but this film is not preferable since the film cause an environmental problem such as generation of dioxin at the time of incineration, or the like. Therefore, a polyester-based heat-shrinkable film has been prominent as a means capable of replacing the paper label.

As a method of using the polyester-based heat-shrinkable film as the label, a method of using a sticker form, a method of performing printing on the film as in an existing the paper label to attach the printed film using a water soluble adhesive, or the like, may be considered.

In the method of attaching the label using an adhesive as the paper label, the adhesive may be first applied onto a back layer of the label using a gravure printing method, or the like, and then the adhesive applied label may be attached to a bottle. However, in the case of the polyester-based heat-shrinkable film label on which a print layer is formed, a curling phenomenon of the label itself may be severe, such that it may be difficult to easily utilize a process of attaching the paper label according to the related art.

In addition, in a glass bottle colored for UV-blocking, or the like, such as a beer bottle, or the like, a printing effect of a general label may be insufficient, and in the case in which the label is made of a film material, there is a problem in increasing an advertisement effect of using the label.

[Disclosure]

[Technical Problem]

An object of the present invention is to provide a polyester-based metalizing film capable of implementing a vivid metalizing color at the time of being used as a label, increasing an advertisement effect, and having easy processability in an on-line adhesion process while maintaining a shrinkage property.

Another object of the present invention is to provide an eco-friendly bottle capable of increasing an advertisement effect by attaching a label including the polyester-based metalizing film as described above thereto and capable of preventing generation of waste water by removing the label using only hot water at the time of recycling the bottle.

Still another object of the present invention is to provide a method of manufacturing a label-attached bottle capable of transferring a label, applying an adhesive, and attaching the label to the bottle may be performed in a single process in spite of using a film label.

[Technical Solution]

In one general aspect, a polyester-based metalizing film includes: a heat-shrinkable polyester-based film base; a metal deposition layer formed on the base; and a back layer formed on the other surface of the heatshrinkable polyester-based film as an embossing layer formed by physically or chemically treating a surface of the heatshrinkable polyester-based film or a white pigment coatinglayer, wherein a stiffness of the film in a maximum shrinkage direction is 1.5 to 13 g/mm2, and a curl characteristic value defined by a detailed description is 5mm or less.

The polyester-based metalizing film may further include a primer layer formed between the metal deposition layer and the print layer.

The polyester-based metalizing film may further include a protective layer formed on the print layer.

In the polyester-based metalizing film according to the present invention, the protective layer may be a rein layer made of any one selected from copolyester, an acrylic copolymer, a styrene copolymer, a methacrylate copolymer, polystyrene, vinyl acetate, polyamide, alkylacrylate, ureaformaldehyde, epoxydized soybean oil, an ethylene-vinyl acetate copolymer, beef tallow-based oleamide, polyethylene glycol distearate, polyvinylidene, a polyolefin-based copolymer, a urethane resin, and a vinyl-based resin, or a mixture thereof.

The stiffness of the polyester-based metalizing film in the maximum shrinkage direction may be 1.5 to 13.0g/mm$^2$.

The heat-shrinkable polyester-based film base may have a thickness of 35 to 65$\mu$m.

The heat-shrinkable polyester-based film base may be a uniaxially oriented heat-shrinkable polyester-based film base or a biaxially oriented heat-shrinkable polyester-based film base.

The metal deposition layer may have an optical density of 1.0 to 3.5.

The heat-shrinkable polyester-based film base may contain a polyester-based resin including a butylene terephthalate repeating unit.

The heat-shrinkable polyester-based film base may contain at least one copolyester selected from copolyesters obtained from dicarboxylic acid component including at least one dicarboxylic acid such as terephthalic acid, oxalic acid, malonic acid, succinic acid, adipic acid, suberic acid, azelaic acid, sebacic acid, phthalic acid, isophthalic acid, naphthalene dicarboxylic acid, diphenyl ether carboxylic acid, and a diol component including at least one diol such as ethylene glycol, neopentyl glycol, propylene glycol, trimethylene glycol, tetramethylene glycol, hexamethylene glycol, diethylene glycol, polyalkylene glycol, 1,4-cyclohexane dimethanol.

In the copolyester, a ratio of a terephthalic acid monomer among the dicarboxylic acid monomers may be 80 mole% or more, and a ratio of other monomers except for ethylene glycol among the diol monomers may be 12 to 24 mole%.

In the case in which the polyester-based metalizing film is treated with hot water at 90 for 10 seconds, a shrinkage ratio in the maximum shrinkage direction may be 40 to 80%.

A shrinkage initiation temperature of the polyester-based metalizing film in the maximum shrinkage direction may be 68 to 94°C.

A maximum shrinkage temperature of the polyester-based metalizing film in the maximum shrinkage direction may be 80 to 110°C, and a maximum shrinkage stress thereof may be 0.60 to 1.80kg/mm$^2$.

The polyester-based metalizing film may have a total transmittance of 0.01 to 5%.

The heat-shrinkage polyester-based film base may have a haze of 0.3 to 10%.

In the polyester-based metalizing film, a curl characteristic value defined by a detailed description may be 5mm or less.

In another general aspect, a label-attached bottle includes the polyester-based metalizing film as described above.

The polyester-based metalizing film may be removed by immersing the bottle in hot water.

In another general aspect, a method of manufacturing a label-attached bottle includes: applying an adhesive onto a position to which a label is attached; and attaching the polyester-based metalizing film as described above to a surface onto which the adhesive is applied.

[Advantageous Effects]

The polyester-based metalizing film according to the embodiment of the present invention may implement vivid deposition colors while maintaining a shrinkability to thereby improve the advertisement effect and maintain stiffness at a level similar to that of the paper label for easy processability at the time of attaching the polyester-based metalizing film to a bottle. In addition, at the time of using the polyester-based metalizing film instead of the existing paper label, transferring of a label, application of an adhesive, and attachment to a bottle may be performed in a single process line, such that the existing paper label line may be used as it is. Further, the obtained bottle to which the heat-shrinkable polyester-based label is attached has an excellent print appearance and shielding property, and at the time of recycling the bottle, since the label may be removed using only hot water, generation of waste water may be prevented, such that the label using polyester-based metalizing film may be eco-friendly.

[Description of Drawings]

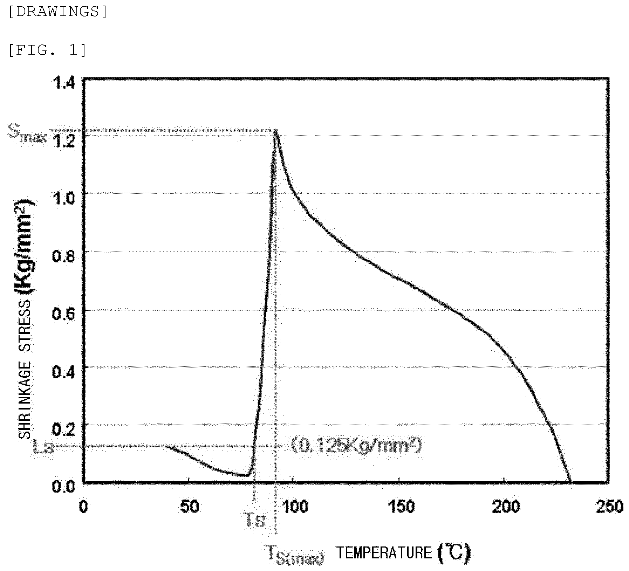

FIG. 1 is a graph obtained by observing a shrinkage stress value change of a polyester-based metalizing film obtained in Example 1 in a maximum shrinkage direction according to the temperature change using a thermal stress tester.

[Best Mode]

A polyester-based metalizing film according to an aspect of the present invention includes a heat-shrinkable polyester-based film base; a metal deposition layer formed on the base; and a back layer formed on the other surface of the heatshrinkable polyester-based film as an embossing layer formed by physically or chemically treating a surface of the heatshrinkable polyester-based film or a white pigment coatinglayer, wherein a stiffness of the film in a maximum shrinkage direction is 1.5 to 13 g/mm2, and a curl characteristic value defined by a detailed description is 5mm or less.

As used herein, the term "heat-shrinkable polyester-based film base" may be considered as a film base containing a polyester-based resin as a main matrix configuring a film and manufactured according to the principle that the maximum uniaxial or biaxial orientation is formed by low-temperature uniaxial or biaxial stretching, the oriented molecular chain keeps residual stress as it is by excluding a releasing process of the residual stress using heat treatment, and the film base is shrunk by the residual stress force in a final shrinkage process.

A composition of the heat-shrinkable polyester-based film base as described above is not particularly limited. For example, the heat-shrinkable polyester-based film base may be made of at least one copolyester selected from copolyesters obtained from dicarboxylic acid component including at least one dicarboxylic acid known in the art such as terephthalic acid, oxalic acid, malonic acid, succinic acid, adipic acid, suberic acid, azelaic acid, sebacic acid, phthalic acid, isophthalic acid, naphthalene dicarboxylic acid, diphenyl ether carboxylic acid, or the like and a diol component including at least one diol known in the art such as ethylene glycol, neopentyl glycol, propylene glycol, trimethylene glycol, tetramethylene glycol, hexamethylene glycol, diethylene glycol, polyalkylene glycol, 1,4-cyclohexane dimethanol, or the like; or a mixture of a homopolyester and the copolyester.

The copolyester itself may be prepared by a general method for preparing polyester. For example, a direct esterification method of directly reacting diol with dicarboxylic acid, a transesterification method of allowing diol to act on dimethylester of dicarboxylic acid, or the like, may be used.

In this case, the copolyester may be copolyester in which a ratio of a terephthalic acid monomer among the dicarboxylic acid monomers is 80 mole% or more, and a ratio of other monomers except for ethylene glycol among the diol monomers is 12 to 24 mole% or more. In the copolyester, the monomers except for the ethylene glycol monomer serve to deteriorate crystallinity of a polyester polymer to increase a shrinkage rate. It may be advantageous in view of controlling a drying process, film processability, and controlling melting property and physical properties during a manufacturing process of the film that a ratio of the corresponding monomer is within the above-mentioned range.

In the present invention, the copolyester itself may be prepared by a general method for preparing polyester. For example, a direct esterification method of directly reacting diol with dicarboxylic acid, a transesterification method of allowing diol to act on dimethylester of dicarboxylic acid, or the like, may be used.

According to the embodiment of the present invention, the copolyester has a melting point (°C) of 190 to 220°C and an inherent viscosity of 0.60 to 0.75dl/g. In this case, the melting point (°C) may be controlled according to the composition of the monomers used to prepare the polymer and the inherent viscosity may change according to the polymerization degree. In the present invention, the copolyester having the melting point (°C) and the inherent viscosity within the above-mentioned ranges may be used by controlling the composition of the monomers and the polymerization degree as described above.

Meanwhile, as the homopolyester, polytriethylene terephthalate may be used instead of polybutylene terephthalate or be used together with polybutylene terephthalate.

In manufacturing the heat-shrinkable polyester-based film base, in order to improve a slip property, a lubricant such as silicon dioxide, titanium dioxide, silica powder, calcium carbonate, or the like, may be added, and various additives such as an antistatic agent, an anti-aging agent, a UV blocker, a pigment may be added, as needed.

Meanwhile, the heat-shrinkable polyester-based film base needs to be manufactured as a film roll by rolling or winding a long film at a high speed in view of improving productivity in a film forming process or post-processing process. In this case, the heat-shrinkable polyester-based film base may include an in-line coating layer containing the antistatic agent on a surface layer.

As used herein, the term "in-line coating layer" may be considered by those skilled in the art as a layer formed by performing a coating process in any one process of processes for extruding a polyester resin to form a film.

In the case in which the in-line coating layer containing the antistatic agent is formed on the surface layer of the film as described above, a phenomenon that films stick to each other during the winding process of the film roll may be removed by reducing static electricity generated by friction, which may be advantageous in that air introduced during the winding process of the film roll may be easily discharged. In addition, a printing defect by static electricity generated by friction between a printing roll and the film during a printing process is prevented, and a phenomenon that the films stick to each other by static electricity during the post-processing process is removed, thereby making it possible to control a feeding defect.

A kind of antistatic agent is not particularly limited. An example thereof may include a quaternary ammonium compound, an alkyl sulfonate compound represented as $RSO_3Na$, an alkyl sulfate compound represented by $ROSO_3Na$,

an alkyl phosphate compound, or the like. A content of the antistatic agent is 0.1 to 1.5 weight% based on active ingredients in a solution for forming the in-line coating layer, which may be preferable in that a generation amount of foreign materials generated by friction during the printing process may be minimized to obtain excellent processability and antistatic performance.

Meanwhile, the in-line coating layer may contain a binder resin in consideration of binding force and adhesion force. In this case, the binder resin is not particularly limited.

A considerable example of the binder resin may include a polyester-based resin, an acryl-polyester copolymer, copolyester-based resin, and the like.

In view of implementing vivid deposition colors at the time of forming the metal deposition layer, it is preferable that the heat-shrinkable polyester-based film base has a haze of 0.3 to 10.0%.

The heat-shrinkable polyester-based film base has a thickness of 35 to 65$\mu$m, preferably 40 to 60$\mu$m, which may be advantageous in view of feeding stability of a label and uniformity of attachment of the label to a bottle when a final product obtained by completing deposition and printing is attached to the bottle.

As described above, the embodiment of the present invention may also include a biaxially shrinkable film as well as uniaxially oriented heat-shrinkable film, but is not limited thereto. However, the biaxially shrinkable film may be advantageous in that a curling phenomenon may be further reduced during a process of manufacturing the label, attaching the label to the bottle, or the like, and then detaching the label from the bottle.

Meanwhile, the polyester-based metalizing film according to the present invention includes the metal deposition layer formed on the heat-shrinkable polyester-based film base.

An example of a metal used in the metal deposition layer may include Al, Zn, Mg, Sn, Ti, In, Cr, Ni, Cu, Pb, and Fe. Among them, Al, Zn, and Mg may be preferable, and particularly, Al may be most preferable in view of productivity.

In view of stability of a deposition process and implementation of a shielding effect, it is advantageous that a thickness of the surface metal deposition layer is 20 to 90nm, preferably, 40 to 70nm. In addition, the metal deposition layer has an optical density of 1.0 to 3.5, which may be advantageous in view of maintaining stiffness and implementing stability of the deposition process and the shielding effect.

Even though a method of forming the metal deposition layer is not particularly limited, a physical deposition method such as a vacuum deposition method, a sputtering method, an ion plating method, or the like, or a chemical deposition method such as a chemical vapor deposition (CVD) method, or the like, may be used.

The polyester-based metalizing film according to the present invention includes the print layer formed on the metal deposition layer.

The print layer on which items associated with the contents filled in a vessel, advertisement, and warnings are printed as letters or figures serves to promote a product. As a method of forming the print layer as described above, a method known in the art may be used. For example, a gravure printing method, a flexo printing method, a screen printing method, or the like, may be used. In view of performing a function as a print layer and preventing the print layer from being broken, it is preferable that a thickness of the print layer is 0.5 to 10$\mu$m.

As needed, the primer layer may be further included between the metal deposition layer and the print layer. The primer layer may increase adhesive strength between the metal deposition layer and the print layer to impart scratch resistance to the print layer and serve to prevent contamination generation by separation of the print layer during a bottle washing process for removing the label from the bottle. The primer layer as described above may be appropriately selected in consideration of the print layer, but is not limited thereto.

Further, in order to obtain the adhesive strength, the surface of the heat-shrinkable polyester-based film base may be subjected to corona treatment, flame treatment, plasma treatment, glow discharge treatment, surface roughening treatment, or the like, before the metal deposition layer is formed.

In addition, the protective layer may be further formed on the print layer, which is to impart weather resistance or durability to the metal deposition layer in addition to protecting the print layer. A composition of the protective layer is not particularly limited. For example, the protective layer may be a resin layer made of any one selected from copolyester, an acrylic copolymer, a styrene copolymer, a methacrylate copolymer, polystyrene, vinyl acetate, polyamide, alkylacrylate, ureaformaldehyde, epoxydized soybean oil, an ethylene-vinyl acetate copolymer, beef tallow-based oleamide, polyethylene glycol distearate, polyvinylidene, a polyolefin-based copolymer, a urethane resin, and a vinyl-based resin, or a mixture thereof.

The protective layer has a thickness of 0.1 to 5.0$\mu$m, preferably 0.3 to 1.0$\mu$m, which may be advantageous in view of coating stability of the protective layer and stability of the drying process.

Further, in order to use the polyester-based metalizing film according to the present invention as the label, the label needs to be easily dried and satisfy a suitable shielding property after being attached by an adhesive.

Therefore, the other surface of the heat-shrinkable polyester-based metalizing film base may be provided with the back layer.

The back layer may be an embossing layer formed by physically or chemically treating the surface of the heat-shrinkable polyester-based film base or a white pigment coating layer.

In the case in which the embossing layer is formed by physically or chemically treating the surface of the heat-shrinkable polyester-based film base, when the adhesive is applied onto the deposition film and the deposition film is attached to the bottle and then dried, drying efficiency may be improved and a drying time may be reduced due to an air layer formed in the embossing layer.

The back layer may be a separate coating layer rather than the embossing layer as described above. More specifically, the back layer may be the white pigment coating layer. In the case of forming the white pigment coating layer, the shielding property of the deposition film may be improved, and a micro embossing effect by surface roughness may be obtained, such that the drying efficiency of the adhesive applied onto the film may be improved and the drying time thereof may be reduced.

Meanwhile, in an example of the known method of attaching a paper label, particularly, a sheet of the paper label to a glass bottle, or the like, while a label including a print layer formed thereon and having a predetermined size is transferred, an adhesive is applied thereto using a gravure printing method, or the like, and the adhesive applied label is continuously attached to the bottle (this is referred to as an "on-line adhesion process"). In the case of the paper label, suitable flatness may be maintained even after the print layer is formed, but in the case of the heat-shrinkable polyester-based film, when the white pigment coating layer is formed on one surface of the base, the curling phenomenon of the film may become severe due to a coating solution. Therefore, it may be difficult to apply the film label in bottle manufacturers, liquor manufacturers using the paper label according to the related art, and the like.

Considering this difficulty, in the case in which the back layer is a coating layer containing a solvent such as the white pigment coating layer, a curl characteristic value as defined below may be preferably 5mm or less.

Curl characteristic value :

A heat-shrinkable polyester deposition film subjected to various processing processes was put on a flat glass plate, and the film was cut in a transverse direction at a length of 20cm without damage using a cutter and a ruler on the deposition film, thereby forming a first cutting line. Then, the film was cut again in a machine direction (a direction perpendicular to the first cutting line) at a length of 20cm based on a central point of the first cutting line without damage using the ruler and the cutter, thereby forming a second cutting line. Thereafter, four cutting lines having a distance of 10cm from a crossing point between the first and second cutting lines in the transverse and machine directions were formed, respectively. With respect to the deposition film having the 4 cutting lines in the transverse and machine directions, in order to confirm that the cutting was completed, a cutting state was confirmed by raising the deposition film in a vertical direction. The deposition film is put on the flat glass plate again, and a vertical height of an edge portion lifted from a flat surface to thereby be flexibly raised is measured at each of the four edges corresponding to crossing points of the cutting lines. In this case, after measurement is performed on the case in which the deposition layer is set as an upper surface and the case in which the deposition layer is set as a lower surface, respectively, a value indicating the maximum height is defined as a "curl characteristic value ".

In the case in which the curl characteristic value defined as described above is 5mm or less, the adhesion process may be easily performed at the time of applying the deposition film according to the embodiment of the present invention as the label.

As an example, the white pigment coating layer includes at least one resin selected from an acrylic resin, a polyurethane-based resin, an ethylene-vinyl acetate copolymer, a vinyl-based resin and is made of a composition including a solvent, a white pigment, and additives such as an anti-precipitator, a thickening agent, a color-separation preventing agent, a pigment dispersant, or the like, which may be preferable in that the warpage phenomenon of the heat-shrinkable polyester-based film base may be easily controlled.

In this case, the solvent for preparing a solution is not particularly limited, but in consideration of the solvent used to form the print layer, at least one kind selected from aromatic hydrocarbon-based solvents, ketone-based solvents, acetate-based solvents, chlorine-based solvents, and alcohol-based solvents may be used.

The white pigment coating layer has a thickness of 0.1 to 5$\mu$m, preferably 0.4 to 2$\mu$m, which may be advantageous in view of coating stability of the back layer, stability of the drying process, and prevention of the warpage phenomenon of the label by the solvent.

In the case of the polyester-based metalizing films according to the embodiments of the present invention, the stiffness of the film in the maximum shrinkage direction may be 1.5 to 13.0g/mm$^2$.

The stiffness of the film described above and below may be a value defined as follows.

Stiffness:

A heat-shrinkable polyester deposition film subjected to various processing processes is cut into a rectangle having a size of 300mm $\times$ 15mm in the maximum shrinkage direction and a direction perpendicular thereto, and measurement is performed thereon using a stiffness tester (Toyo Seiki Co.) to thereby confirm the maximum value (bending stiffness) of the stiffness, and then the maximum stiffness is divided by the thickness and the width of the measured film, thereby obtaining a calculation value, which is called "stiffness".

In order to replace the existing paper label attached to a glass bottle, or the like, with the polyester-based metalizing film according to the embodiment of the present invention, it is preferable to replace only the paper label with the deposition film label while using the attaching process of the existing paper label as it is or similarly using the attaching process. However, when the deposition film is cut into a label form, the deposition film is not as stiff as the paper label. This point may be disadvantageous in the adhesion process of attaching the label to the bottle, such that productivity may be deteriorated. Considering this problem, in the polyester-based metalizing films according to the embodiments of the present invention, only in the case in which the stiffness as defined above is at least 1.5g/mm$^2$ or more, the polyester-based metalizing films may be maintained so as to be as stiff as the paper label. However, as the stiffness increases, form resilience of the print label increases, such that at the time of attaching the print label to the bottle, the print label may be separated from the bottle before the adhesive is dried, thereby reducing adhesion stability. Therefore, it may be preferable that the stiffness is 13.0g/mm$^2$ or less.

As a method of providing a deposition film satisfying the above-mentioned stiffness, a method of controlling a thickness of a base film of the polyester-based metalizing film, a method of controlling the thickness of the metal deposition layer, or the like, may be considered.

When the polyester-based metalizing films according to the embodiments of the present invention satisfying the above-mentioned configurations is treated with hot water at 90°C for 10 seconds, a shrinkage ratio in the maximum shrinkage direction may be 40 to 80%.

The hot water shrinkage rate range as described above may be advantageous in that separation may be easily performed in a process of separating a label using hot water at the time of recovering an empty bottle to recycle the recovered bottle after attaching the heat-shrinkable film to a bottle, or the like, as a label using an adhesive.

More specifically, in the case in which the polyester-based metalizing film is treated with hot water at 90°C for 10 seconds, when the shrinkage ratio in the maximum shrinkage direction is less than 40%, a time required for shrinkage may be increased, such that at the time of using this polyester-based metalizing film as the label, separation efficiency in a removing process of the label for recycling the bottle may be reduced, and energy cost may be increased. On the other hands, when the shrinkage ratio in the maximum shrinkage direction is more than 80%, the curling phenomenon of the film may become severe due to an excessively high shrinkage speed, such that the label may be fall inside an empty bottle while the label is separated and removed from the bottle in the washing process of the bottle, which results in difficulty to discharge the label from the bottle, thereby causing a problem in the separating and removing process.

Further, in the case in which the polyester-based metalizing film has a shrinkage initiation temperature of 68 to 94°C in the maximum shrinkage direction, when the polyester-based film is used as the label, at the time of removing the label for recycling the bottle, the label may be easily removed with a short time. Here, the shrinkage initiation temperature may be defined as follows.

Shrinkage initiation temperature: An initial temperature at which shrinkage stress is equal to that of an initial load in a graph obtained by fixing the film at room temperature under a predetermined initial load and then measuring stress at the time of shrinkage of the film while heating at a predetermined heating rate to indicate the shrinkage stress according to the temperature as a graph.

As an example of a measuring device capable of implementing the graph as described above, there is a thermal stress test.

For example, in order to confirm heat-shrinking characteristics of the deposition film according to the temperature using the thermal stress tester, firstly, after the film is fixed under the predetermined load, stress changes by shrinkage according to the temperature change are measured while applying heat at the predetermined heating rate.

An example of the measurement graph by the above-mentioned method is shown in FIG. 1. Referring to FIG. 1, an initial point on the graph indicates an initially set load value Ls. When the temperature is raised, initially, the film is softened, such that the stress value is decreased as compared to the initial load value Ls, but when the temperature arrives at a predetermined temperature, the film starts to shrink while becoming tense. At this time, a shrinkage stress value equal to the initial load Ls is observed, and this temperature is defined as a shrinkage initiation temperature Ts.

In the heat-shrinkable polyester-based film according to the present invention, the shrinkage initiation temperature as described above in the maximum shrinkage direction is 68 to 94°C. In the case in which the shrinkage initiation temperature is lower than 68°C, the label may be partially separated from the bottle during a distributing and storing process of a final product in summer, which may has a negative influence on the appearance of the final product, and In the case in which the shrinkage initiation temperature is higher than 94°C, at the time of a label removing process in hot water, a high temperature and a long period of the time are required, thereby increasing process cost.

In addition, a maximum shrinkage temperature of the polyester-based metalizing film in the maximum shrinkage direction according to the present invention is observed in a range of 80 to 110°C. Here, the maximum shrinkage temperature may be defined as an initial temperature at which the maximum shrinkage stress value is shown in a graph obtained by fixing the film at room temperature under a predetermined initial load and then measuring stress at the time of shrinkage of the film while heating at a predetermined heating rate to indicate the shrinkage stress according to the temperature as a graph.

Further, a shrinkage stress value at this time is defined as the maximum shrinkage stress, and the value may be 0.60 to 1.80kg/mm$^2$.

Referring to the graph of the shrinkage stress change according to the temperature change obtained by using a thermal stress tester as shown in FIG. 1, when the shrinkable film starts to shrink, a curve of the shrinkage stress value ascends up to a predetermined temperature, and the curve of the shrinkage stress value descends over a temperature T(Smax) at which the maximum shrinkage stress value Smax is shown.

Here, when the temperature T(Smax) at which the maximum shrinkage stress value Smax is shown is high, at the time of performing hot water treatment for removing the label, a high temperature or a long period of the time is required.

In this regard, in the polyester-based metalizing film according to the present invention, the maximum shrinkage temperature in the maximum shrinkage direction may be 80 to 110°C, and it is advantageous that the maximum shrinkage temperature is low. Further, in view of separation force of the label from the vessel, it is advantageous that the maximum shrinkage stress is 0.6 to 1.80kg/mm$^2$.

In addition, total transmittance of the polyester-based metalizing film according to the present invention may be preferably 0.01 to 5% in order to protect materials in a vessel from the light and increase a printing effect by the shielding property.

A method of manufacturing the polyester-based metalizing films according to the embodiments of the present invention is not particularly limited. For example, a metal deposition layer may be formed by vacuum depositing a metal such as aluminum or the like, on one surface of a heat-shrinkable polyester film base. Then, a print layer is formed on the metal deposition layer. In this case, the print layer may be formed, for example, by 5-times printing using a gravure type printer. Meanwhile, in view of improving scratch resistance of the print layer and preventing the print layer from being separated from the metal deposition layer, the print layer may be formed, for example, after coating a composition for forming the above-mentioned protective layer using the gravure type printer or forming the protective layer on the metal deposition layer. In addition, the back layer may be formed on the other surface of the heat-shrinkable polyester film base, for example, by coating an ink layer in which a white pigment is dispersed in an alcohol-based solvent using the gravure printer or performing physical treatment.

The polyester-based metalizing films according to the embodiments of the present invention may be useful as the label replacing the paper label. According to the embodiment of the present invention, there is provided a label-attached bottle including the polyester-based metalizing film as described above.

As a method of attaching the label including the polyester-based metalizing film to a glass bottle, or the like, a method of attaching a paper label according to the related art may be used. However, as an adhesive, a water soluble adhesive may be used in consideration of a film material and environmental aspects. In the case of applying the water soluble adhesive onto the back layer of the polyester-based metalizing film transferred as a single-sheet form of the label and attaching the adhesive applied surface to the bottle, a label-attached bottle may be manufactured.

In recovering and recycling the label-attached bottle manufactured as described above, removal of the polyester-based metalizing film is performed by immersing the bottle in hot water. In this case, a temperature of the hot water may be sufficient at about 70 to 90°C.

Hereinafter, Examples of the present invention will be described in detail, but the scope of the present invention is not limited to Examples.

Evaluation methods used in the present invention are as follows.

(1) Heat Shrinkage Rate

A film base and a deposition film each were cut into a rectangle having a size of 15mm(MD)× 400mm(TD) in a maximum shrinkage direction (TD: transverse direction) and a direction (MD: machine direction) perpendicular thereto, and a sample having an effective measuring distance of 300mm was manufactured by drawing full lines in the MD direction at points spaced from both ends by 50mm in the TD direction. Then, the sample was heat-shrunk for 10 seconds in a state of catching a point within 50mm from any one end of the sample in the TD direction using tweezers, or the like, to completely immerse the entire sample in hot water at 90°C± 0.5°C under no load condition, and the sample was released at room temperature for 1 minute. Thereafter, a length reduced from the interval of 300mm represented by the initial full lines in the TD direction was measured, and the heat shrinkage ratio in the maximum shrinkage direction (TD direction) of the film was calculated according to the following Equation 1.

<Equation 1>

$$\text{Heat shrinkage ratio (\%)} = (300\text{mm} - \text{length after shrinkage} / 300\text{mm}) \times 100$$

(2) Thickness Measurement

After the film sample was rapidly frozen by being immersed in liquid nitrogen, the film sample was broken in the liquid nitrogen, and a cross section thereof was measured using a scanning electronic microscope (SEM, Jeol Inc. 6700F). In addition, a thickness of each of the layers configuring the film was measured by adjusting magnification and using a scale bar.

Further, after the thickness of each of the film base and the deposition film was measured by an interval of 5cm using a thickness gauge with respect to the entire width, an average value of the measured values except for the maximum and minimum values was calculated as the thickness.

(3) Haze

The haze was measured according to ASTM D-1003. after 7 portions were randomly extracted from 2 peripheral portions of a polyester film and a central portion thereof and cut at a size of 5cm× 5cm, respectively, each cut fraction was put into a haze meter (Nippon Denshoku, NDH 5000) and a measuring method was set according to ASTM. Thereafter, the haze (%) was measured by transmitting light, and an average value of the 5 values except for the maximum and minimum values was calculated as the haze.

(4) Stiffness

After a heat-shrinkable polyester deposition film was cut into a rectangle having a size of 300mm × 15mm in a maximum shrinkage direction and a direction perpendicular thereto, and the cut rectangular film was mounted on a stiffness tester (Toyo Seiki Co.), thereby obtaining a bending stiffness value. At the time of mounting a sample on the stiffness tester, the sample was mounted so that a load cell contacts a central portion of the film in order to obtain accurate measurement value, and in order to mount the sample on the tester in a flat state, the sample was mounted under tension of 0.125kg/mm$^2$. At the time of measuring the bending stiffness, a stiffness value initially increased to arrive at the maximum value, and then decreased. Here, bending stiffness means the maximum value. After samples were extracted from 5 portions within 1 m in a length direction of the film and stiffness values of the samples were measured, respectively, an average value thereof was obtained, and the obtained average value was divided by a width (15mm) of the film and the thickness of the film, thereby calculating stiffness according to the following Equation 2.

<Equation 2>

$$\text{Stiffness}(g/mm^2) = \frac{\text{Average value of bending stiffness}(g)}{\text{Film width}(15mm) \times \text{film thickness}(mm)}$$

(5) Total Transmittance

The total transmittance was measured according to ASTM D-1003. After 7 portions were randomly extracted from 2 peripheral portions of a polyester deposition film and a central portion thereof and cut at a size of 5cm× 5cm, respectively, each cut fraction was put into a haze meter (Nippon Denshoku, NDH 5000) and a measuring method was set according to ASTM. Thereafter, the total transmittance (%) was measured by mounting the sample so as to allow light to be incident onto a metal deposition layer and to be transmitted toward a back layer, and an average value of the 5 values except for the maximum and minimum values was calculated as the total transmittance.

(6) Optical Density (OD)

After a metal position layer was formed on a polyester film, 7 portions were randomly extracted from 2 peripheral portions and a central portion of the film in a width direction of the film and cut at a size of 5cm× 5cm, respectively.

Then, each of the samples was mounted so as to allow light to be incident onto the metal deposition layer and to be transmitted toward a back layer, and the optical density (OD) was measured using an optical densitometer (Gretagmacbeth Corp., iCFilm). Thereafter, an average value of the 5 values except for the maximum and minimum values was calculated as the optical density (OD).

(7) Shrinkage Initiation Temperature, Maximum Shrinkage Temperature, and Maximum Shrinkage Stress

The principle applied to analyzing a shrinkage initiation temperature, a maximum shrinkage temperature, and maximum shrinkage stress of the polyester-based metalizing film according to the present invention in a maximum shrinkage direction, and the shrinkage initiation temperature, the maximum shrinkage temperature, and the maximum shrinkage derived therefrom will be defined as follows.

1) Principle

A polymer chain is oriented and crystallized during a stretching process and has a structure divided into a crystalline region and an amorphous region. When the stretched polymer is heated, a relaxation phenomenon of stress remaining in the polymer chain and a shrinkage phenomenon of returning to its original shape may occur. Force inhibiting the shrinkage as described above is called shrinkage stress, and the higher the shrinkage stress, the higher the shrinkage force according to the temperature under the same conditions.

After fixing a film at room temperature under a predetermined initial load, when the film is heated at a predetermined heating rate, stress changes due to expansion and shrinkage of the sample according to the temperature change may be derived by a detection method of using a linear variable differential transformer (LVDT). Information on the shrinkage stress of the film according to the temperature change may be obtained using this principle. In this case, since the heating rate depends on a residual stress relaxation rate of the polymer chain, in the present invention, the shrinkage stress value according to the temperature change was measured at a heating rate of 2.5°C/sec.

A graph of the measured values shows a pattern as shown in FIG. 1. Here, a temperature at which a shrinkage stress value equal to an initial load value Ls is initially observed is defined as a shrinkage initiation temperature Ts, a temperature at which a value corresponding to a peak of the graph is obtained is defined as a maximum shrinkage temperature T(Smax), and a stress value at T(Smax) is defined as a maximum shrinkage stress Smax. As an example of a device implementing the principle as described above, a thermal stress tester (KE-2, Kanebo Eng.) was used in the following Examples and Comparative Examples.

After a film sample having a width of 4mm (MD direction) and a length of 50mm (TD direction) was fixed under an initial load of 0.125kg/mm$^2$ using the thermal stress tester (KE-2, Kanebo Eng.), shrinkage stress according to the temperature was measured while heating at a heating rate of 2.5°C/sec, thereby obtaining a graph.

In this graph, a temperature at which a shrinkage stress value equal to the initial load of 0.125kg/mm$^2$ was initially observed was defined as a shrinkage initiation temperature Ts, a temperature at which a maximum shrinkage stress value initially appeared was defined as a maximum shrinkage temperature T(Smax), and a stress value at T(Smax) was defined as a maximum shrinkage stress Smax.

(8) Curl characteristic value

A polyester-based metalizing film subjected to various processing processes was put on a polished glass plate having a refractive index of 1.567, and the film was cut in a transverse direction at a length of 20cm without damage using a cutter and a ruler on the deposition film, thereby forming a first cutting line. Then, the film was cut again in a machine direction (a direction perpendicular to the first cutting line) at a length of 20cm based on a central point of the first cutting line without damage using the ruler and the cutter, thereby forming a second cutting line. Thereafter, four cutting lines having a distance of 10cm from a crossing point between the first and second cutting lines in the transverse and machine directions were formed, respectively. With respect to the deposition film having the 4 cutting lines in the transverse and machine directions, in order to confirm that the cutting was completed, a cutting state was confirmed by raising the deposition film in a vertical direction. The deposition film was put on the flat glass plate again, and a vertical height of an edge portion lifted from a flat surface to thereby be flexibly raised was measured at each of the four edges corresponding to crossing points of the cutting lines. Here, after measurement was performed on the case in which the deposition layer is set as an upper surface and the case in which the deposition layer is set as a lower surface, respectively, a value indicating the maximum height was defined as a "curl characteristic value ".

(9) Label Adhesion Property Evaluation during Manufacturing Process of Bottle.

After a polyester-based metalizing film label was cut into a square having a size of 80mm× 80mm in a maximum shrinkage direction and a direction perpendicular thereto, an water soluble adhesive prepared by mixing 45 parts by weight of styrene-butadiene rubber latex, 40 parts by weight of acrylic emulsion, 10 parts by weight of ethylene-vinyl emulsion, 0.8 parts by weight of sodium hydroxide, 0.1 part by weight of a sterilizer, and 4.1 parts by weight of water was applied onto a back layer of the polyester-based metalizing film label at a thickness of 5$\mu$m using a gravure printing method, and labeling was performed on 1000 glass bottles (soju bottle) using a labeler. After the labeled 1000 glass bottles were released at room temperature for 2 days, the number of bottles on which the label was wrinkled or an edge of the label was separated was measured, such that the adhesion property was evaluated by obtaining an adhesive failure rate according to the following Equation 3.

<Equation 3>

$$\text{Adhesive failure rate(\%)} = \frac{\text{The number of bottles in which the label was wrinkled or an edge of the label was separated (ea)}}{\text{1000(ea)}} \times 100$$

Adhesion property (%) = 100 - adhesive failure rate (%)

(10) Separation Property Evaluation after the Label was attached to the Bottle

After bottles to which the label normally attached except for the bottles evaluated as label adhesive failure generated bottles in the label adhesion property evaluation as described above were released in hot water at 80°C for 2 minutes, the number of bottles from which the label was completely separated was measured, such that the separation property was evaluated by obtaining a separation failure rate according to the following Equation 4.

<Equation 4>

$$\text{Separation failure rate(\%)} = \frac{\text{The number of bottles from which the label was not completely separated (ea)}}{\text{The number of bottles to which the label was normally attached (ea)}} \times 100$$

Separation property (%) = 100 - separation failure rate (%)

(11) Process Applicability Evaluation of Label

Process applicability of the label was closely associated with the adhesion and separation properties of the label. In view of process applicability, even though one of the adhesion and separation properties was deteriorated, as a result, process applicability was also deteriorated.

Therefore, the process applicability of the label was evaluated according to the following Equation 5.

<Equation 5>

Process applicability (%) = [adhesion property (%)× separation property (%)] / 100

Hereinafter, the present invention will be described in detail with reference to Examples, but the present invention is not limited thereto.

<Example 1>

Polycondensation was performed by a direct esterification method using 100 mole% of terephthalic acid as a dibasic acid component, 100 mole% of ethylene glycol and 24 mole% of neopentyl glycol as glycol components, and antimony trioxide (0.05mole based on an acid component) as a catalyst. Silicon dioxide powder (500ppm) having an average particle size of 2.7$\mu$m was added to the obtained polymer and dried by a method according to the related art, thereby preparing copolyester having an inherent viscosity of 0.71dℓ/g and a melting point of 203°C.

Meanwhile, a polybutylene terephthalate resin (inherent viscosity: 0.97dℓ/g, melting point: 220°C) was obtained using 100 mole% of terephthalic acid and 100 mole% of 1,4-butadiene by injecting 0.015 parts by weight of tetrabutyl titanate as a catalyst.

90 weight% of the copolyester and 10 weight% of polybutylene terephthalate were blended with each other and extruded at 270°C using an extruder, followed by rapid cooling and solidification, thereby obtaining an unstretched film. The unstretched film passed through a roller transferred in a machine direction and a preheating section at 85°C and was stretched 4.2 times at 75°C in a transverse direction. Then, the stretched film passed through a heat treating section at room temperature, thereby manufacturing a film. The obtained film was a heat-shrinkable film having a thickness of 50$\mu$m, and a heat shrinkage rate and a haze measured by the methods as described above were 76.5% (TD direction) and 5.7%, respectively.

An aluminum metal deposition layer having an optical density (OD) of 2.43 was formed on the obtained polyester-based heat-shrinkable film by depositing aluminum having a purity of 99.9% using a boat type evaporator under conditions at which a degree of vacuum at an upper portion of the evaporator was $2.2\times 10^{-2}$mbar, a degree of vacuum at a lower portion of the evaporator was $5.8\times 10^{-4}$mbar, a cooling roll temperature was -16°C, and a deposition rate was 400m/min.

A print layer having a thickness of 1.8$\mu$m was formed on the metal deposition layer from five kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a yellow pigment (Yellow 10G, Hyundai Chemical), a red pigment (Red-FRN, Hyundai Chemical), a green pigment (Green 735, Hyundai Chemical), a black pigment (Black #30, Hyundai Chemical), and a white pigment (R-100, KPI) to have the entire content of 100 weight% by 5-times printing using a gravure roll.

A coating solution having a solid content of 25 weight% was prepared by diluting a mixed varnish composed of 10 weight% of urethane (urethane varnish) and 90 weight% of vinyl chloride (vinyl chloride varnish) with methylethylketone (MEK) and used on the print layer using a gravure roll. A protective layer having a thickness of 0.5$\mu$m was formed on the print layer using this coating solution.

Meanwhile, a back layer having a thickness of 1.0$\mu$m was formed from the solution containing 10 weight% of the acrylic resin (BPS-5968, Samyoung Toyo), 80 weight% of methylethylketone, and 10 weight% of the white pigment (R-100, KPI) among the solutions for forming the print layer by 1-times printing using a gravure roll, thereby manufacturing a deposition film according to the present invention.

The obtained deposition film was evaluated by the above-mentioned methods, and the results were shown in the following Tables 1 and 2.

<Example 2>

Polycondensation was performed by a direct esterification method using 100 mole% of terephthalic acid as a dibasic acid component, 107 mole% of ethylene glycol and 17 mole% of neopentyl glycol as glycol components, and antimony trioxide (0.05mole based on an acid component) as a catalyst. Silicon dioxide powder (500ppm) having an average particle size of 2.7$\mu$m was added to the obtained polymer and dried by a method according to the related art, thereby preparing copolyester having an inherent viscosity of 0.63d#/g and a melting point of 218°C.

90 weight% of the copolyester and 10 weight% of polybutylene terephthalate in Example 1 were blended with each other and extruded at 270°C using an extruder, followed by rapid cooling and solidification, thereby obtaining an unstretched film. The unstretched film passed through a roller transferred in a machine direction and a preheating section at 94°C and was stretched 3.9 times at 70°C in a transverse direction. Then, the stretched film passed through a heat treating section at 92°C, thereby manufacturing a heat-shrinkable film having a thickness of 65$\mu$m.

An aluminum metal deposition layer having an optical density (OD) of 2.35 was formed on the obtained polyester-based heat-shrinkable film by depositing aluminum having a purity of 99.9% using a boat type evaporator under conditions at which a degree of vacuum at an upper portion of the evaporator was $2.1\times 10^{-2}$mbar, a degree of vacuum at a lower portion of the evaporator was $5.6\times 10^{-4}$mbar, a cooling roll temperature was -16°C, and a deposition rate was 400m/min.

A print layer and a protective layer were formed on the metal deposition layer and a back layer was formed on the other surface under the same conditions as those in Example 1, thereby manufacturing a deposition film according to the present invention, including a print layer having a thickness of 1.8μm, a protective layer having a thickness of 0.5μm, and a back layer having a thickness of 1.0μm. The obtained deposition film was evaluated by the above-mentioned methods, and the results were shown in the following Tables 1 and 2.

<Example 3>

Polycondensation was performed by a direct esterification method using 100 mole% of terephthalic acid as a dibasic acid component, 96 mole% of ethylene glycol and 28 mole% of neopentyl glycol as glycol components, and antimony trioxide (0.05mole based on an acid component) as a catalyst. Silicon dioxide powder (50ppm) having an average particle size of 2.7μm was added to the obtained polymer and dried by a method according to the related art, thereby preparing copolyester having an inherent viscosity of 0.73dℓ/g and a melting point of 193°C.

90 weight% of the copolyester and 10 weight% of polybutylene terephthalate in Example 1 were blended with each other and extruded at 270°C using an extruder, followed by rapid cooling and solidification, thereby obtaining an unstretched film. The unstretched film passed through a roller transferred in a machine direction and a preheating section at 84°C and was stretched 4.2 times at 70°C in a transverse direction. Then, the stretched film passed through a heat treating section at room temperature, thereby manufacturing a heat-shrinkable film having a thickness of 35μm.

An aluminum metal deposition layer having an optical density (OD) of 2.53 was formed on the obtained polyester-based heat-shrinkable film by depositing aluminum having a purity of 99.9% using a boat type evaporator under conditions at which a degree of vacuum at an upper portion of the evaporator was $2.2\times 10^{-2}$mbar, a degree of vacuum at a lower portion of the evaporator was $5.3\times 10^{-4}$mbar, a cooling roll temperature was -20°C, and a deposition rate was 390m/min.

A print layer and a protective layer were formed on the metal deposition layer and a back layer was formed on the other surface under the same conditions as those in Example 1, thereby manufacturing a deposition film according to the present invention, including a print layer having a thickness of 1.8μm, a protective layer having a thickness of 0.5μm, and a back layer having a thickness of 1.0μm. The obtained deposition film was evaluated by the above-mentioned methods, and the results were shown in the following Tables 1 and 2.

<Example 4>

Polycondensation was performed by a direct esterification method using 100 mole% of terephthalic acid as a dibasic acid component, 82 mole% of ethylene glycol and 18 mole% of 1.4-cyclohexane dimethanol as glycol components, and antimony trioxide (0.05mole based on an acid component) as a catalyst. Silicon dioxide powder (500ppm) having an average particle size of 2.7μm was added to the obtained polymer and dried by a method according to the related art, thereby preparing copolyester having an inherent viscosity of 0.70d#/g and a melting point of 205°C.

The copolyester was extruded at 270°C using an extruder, followed by rapid cooling and solidification, thereby obtaining an unstretched film. The unstretched film passed through a roller transferred in a machine direction and a preheating section at 82°C and was stretched 4.2 times at 70°C in a transverse direction. Then, the stretched film passed through a heat treating section at room temperature, thereby manufacturing a heat-shrinkable film having a thickness of 50μm.

An aluminum metal deposition layer having an optical density (OD) of 2.25 was formed on the obtained polyester-based heat-shrinkable film by depositing aluminum having a purity of 99.9% using a boat type evaporator under conditions at which a degree of vacuum at an upper portion of the evaporator was $2.0\times 10^{-2}$mbar, a degree of vacuum at a lower portion was $5.0\times 10^{-4}$mbar, a cooling roll temperature was -15°C, and a deposition rate was 350m/min.

A print layer and a protective layer were formed on the metal deposition layer and a back layer was formed on the other surface under the same conditions as those in Example 1, thereby manufacturing a deposition film according to the present invention, including a print layer having a thickness of 1.8μm, a protective layer having a thickness of 0.5μm, and a back layer having a thickness of 1.0μm. The obtained deposition film was evaluated by the above-mentioned methods, and the results were shown in the following Tables 1 and 2.

<Example 5>

Polycondensation was performed by a direct esterification method using 100 mole% of terephthalic acid as a dibasic acid component, 102 mole% of ethylene glycol and 22 mole% of neopentyl glycol as glycol components, and antimony trioxide (0.05mole based on an acid component) as a catalyst. Silicon dioxide powder (500ppm) having an average particle size of 2.7μm was added to the obtained polymer and dried by a method according to the related art, thereby obtaining copolyester having an inherent viscosity of 0.71dℓ/g and a melting point of 203°C.

The copolyester was extruded at 270°C using an extruder, followed by rapid cooling and solidification, thereby obtaining an unstretched film. The unstretched film passed through a roller transferred in a machine direction and a preheating section at 92°C and was stretched 4.2 times at 70°C in a transverse direction. Then, the stretched film passed through a heat treating section at 85°C, thereby manufacturing a heat-shrinkable film having a thickness of 50$\mu$m.

An aluminum metal deposition layer having an optical density (OD) of 2.43 was formed on the obtained polyester-based heat-shrinkable film under the same conditions as those in Example 1.

A print layer and a protective layer were formed on the metal deposition layer and a back layer was formed on the other surface under the same conditions as those in Example 1, thereby manufacturing a deposition film according to the present invention, including a print layer having a thickness of 1.8$\mu$m, a protective layer having a thickness of 0.5$\mu$m, and a back layer having a thickness of 1.0$\mu$m. The obtained deposition film was evaluated by the above-mentioned methods, and the results were shown in the following Tables 1 and 2.

<Example 6>

A heat-shrinkable film was manufactured by the same method as in Example 1 except that the film passed through a roller transferred in a machine direction and a preheating section at 92°C and was stretched 4.2 times at 70°C in a transverse direction, followed by passing through a heat treating section at 85°C, thereby manufacturing a film having a thickness of 35$\mu$m.

An aluminum metal deposition layer having an optical density (OD) of 1.13 was formed on the obtained polyester-based heat-shrinkable film by depositing aluminum having a purity of 99.9% using a boat type evaporator under conditions at which a degree of vacuum at an upper portion of the evaporator was $0.8\times 10^{-2}$mbar, a degree of vacuum at a lower portion of the evaporator was $2.5\times 10^{-4}$mbar, a cooling roll temperature was -12°C, and a deposition rate was 495m/min.

A print layer and a protective layer were formed on the metal deposition layer and a back layer was formed on the other surface by the same methods as those in Example 1, thereby manufacturing a deposition film according the present invention, including a print layer having a thickness of 1.8$\mu$m, a protective layer having a thickness of 0.2$\mu$m, and a back layer having a thickness of 1.0$\mu$m. The obtained deposition film was evaluated by the above-mentioned methods, and the results were shown in the following Tables 1 and 2.

<Example 7>

A heat-shrinkable film was manufactured by the same method as in Example 6 except that the film passed through a roller transferred in a machine direction and a preheating section at 82°C and was stretched 4.2 times at 70°C in a transverse direction, followed by passing through a heat treating section at room temperature, thereby manufacturing a film having a thickness of 50$\mu$m.

An aluminum metal deposition layer having an optical density (OD) of 3.37 was formed on the obtained polyester-based heat-shrinkable film by depositing aluminum having a purity of 99.9% using a boat type evaporator under conditions at which a degree of vacuum at an upper portion of the evaporator was $2.8\times 10^{-2}$mbar, a degree of vacuum at a lower portion was $8.5\times 10^{-4}$mbar, a cooling roll temperature was -20°C, and a deposition rate was 305m/min.

A print layer and a protective layer were formed on the metal deposition layer and a back layer was formed on the other surface by the same methods as those in Example 1, thereby manufacturing a deposition film according the present invention, including a print layer having a thickness of 1.8$\mu$m, a protective layer having a thickness of 0.5$\mu$m, and a back layer having a thickness of 1.0$\mu$m. The obtained deposition film was evaluated by the above-mentioned methods, and the results were shown in the following Tables 1 and 2.

<Example 8>

A heat-shrinkable film was manufactured by the same method as in Example 1 except that the film passed through a roller transferred in a machine direction and a preheating section at 90 °C and was stretched 4.2 times at 70°C in a transverse direction, followed by passing through a heat treating section at 80 °C, thereby manufacturing a film having a thickness of 50$\mu$m.

An aluminum metal deposition layer having an optical density (OD) of 2.43 was formed on the obtained polyester-based heat-shrinkable film under the same conditions as those in Example 1.

A print layer having a thickness of 3.0$\mu$m was formed on the metal deposition layer from seven kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a yellow pigment (Yellow 10G, Hyundai Chemical), a red pigment (Red-FRN, Hyundai Chemical), a green pigment (Green 735, Hyundai Chemical), a black pigment (Black #30, Hyundai Chemical), a blue pigment (Blue 501, Hyundai Chemical), a brown pigment (Brown HFR, Hyundai Chemical), and a white pigment (R-100, KPI) to have the entire content of 100 weight% by 7-times printing using a gravure roll.

A protective layer were formed on the print layer and a back layer was formed on the other surface under the same conditions as those in Example 1, thereby manufacturing a deposition film according to the present invention, including a protective layer having a thickness of 0.5μm and a back layer having a thickness of 1.0μm. The obtained deposition film was evaluated by the above-mentioned methods, and the results were shown in the following Tables 1 and 2.

<Example 9>

A heat-shrinkable film was manufactured by the same method as in Example 1 except that the film passed through a roller transferred in a machine direction and a preheating section at 82°C and was stretched 4.0 times at 72°C in a transverse direction, followed by passing through a heat treating section at 85°C, thereby manufacturing a film having a thickness of 50μm.

An aluminum metal deposition layer having an optical density (OD) of 2.43 was formed on the obtained polyester-based heat-shrinkable film under the same conditions as those in Example 1.

A print layer having a thickness of 1.0μm was formed on the metal deposition layer from two kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a red pigment (Red-FRN, Hyundai Chemical) and a white pigment (R-100, KPI) to have the entire content of 100 weight% by 2-times printing using a gravure roll.

A protective layer were formed on the print layer and a back layer was formed on the other surface under the same conditions as those in Example 1, thereby manufacturing a deposition film according to the present invention, including a protective layer having a thickness of 0.5μm and a back layer having a thickness of 1.0μm. The obtained deposition film was evaluated by the above-mentioned methods, and the results were shown in the following Tables 1 and 2.

<Example 10>

A deposition film according to the present invention was manufactured by the same method as in Example 8 except that a print layer having a thickness of 8.5μm was formed on the metal deposition layer from nine kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a yellow pigment (Yellow 10G, Hyundai Chemical), a red pigment (Red-FRN, Hyundai Chemical), a green pigment (Green 735, Hyundai Chemical), a black pigment (Black #30, Hyundai Chemical), a blue pigment (Blue 501, Hyundai Chemical), a pink pigment (Pink E, Hyundai Chemical), a brown pigment (Brown HFR, Hyundai Chemical), a violet pigment (Violet E5B, Hyundai Chemical), and a white pigment (R-100, KPI) to have the entire content of 100 weight% by 9-times printing using a gravure roll.

The obtained deposition film was evaluated by the above-mentioned methods, and the results were shown in the following Tables 1 and 2.

<Example 11>

A print layer having a thickness of 2.0μm was formed on the metal deposition layer of Example 1 from five kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a yellow pigment (Yellow 10G, Hyundai Chemical), a red pigment (Red-FRN, Hyundai Chemical), a green pigment (Green 735, Hyundai Chemical), a blue pigment (Blue 501, Hyundai Chemical), and a white pigment (R-100, KPI) to have the entire content of 100 weight% by 5-times printing using a gravure roll. Then, a coating solution having a solid content of 25 weight% was prepared by diluting a mixed varnish composed of 10 weight% of urethane (urethane varnish) and 90 weight% of vinyl chloride (vinyl chloride varnish) with methylethylketone (MEK) and used on the print layer using a gravure roll. A deposition film according to the present invention was manufactured by the same method as in Example 1 except that a protective layer having a thickness of 3.5μm was formed using this coating solution.

The obtained deposition film was evaluated by the above-mentioned methods, and the results were shown in the following Tables 1 and 2.

<Example 12>

A coating solution having a solid content of 25 weight% was prepared by diluting a mixed varnish composed of 90 weight% of an acrylic copolymer (vinyl acetate-acrylic varnish) and 10 weight% of a styrene copolymer (styrene-vinyl varnish) with methylethylketone (MEK) and used on the print layer of Example 11 using a gravure roll. A deposition film according to the present invention was manufactured by the same method as in Example 11 except that a protective layer having a thickness of 1.5㎛ was formed using this coating solution. The obtained deposition film was evaluated by the above-mentioned methods, and the results were shown in the following Tables 1 and 2.

<Example 13>

A coating solution having a solid content of 25 weight% was prepared by diluting a copolyester resin (a copolyester resin prepared by mixing at least two kinds of polyol and polybasic acids and having a number average molecular weight of 5000) with methylethylketone (MEK) and used on the print layer of Example 11 using a gravure roll. A deposition film according to the present invention was manufactured by the same method as in Example 11 except that a protective layer having a thickness of 1.5㎛ was formed using this coating solution. The obtained deposition film was evaluated by the above-mentioned methods, and the results were shown in the following Tables 1 and 2.

<Example 14>

A deposition film according to the present invention was manufactured by the same method as in Example 1 except that a back layer having a thickness of 2.0㎛ was formed from two kinds of solutions containing the yellow pigment (Yellow 10G, Hyundai Chemical) and the white pigment (R-100, KPI) among the solutions for forming the print layer by 2-times printing using a gravure roll. The obtained deposition film was evaluated by the above-mentioned methods, and the results were shown in the following Tables 1 and 2.

<Example 15>

A deposition film according to the present invention was manufactured by the same method as in Example 1 except that a thickness of a heat-shrinkable film was 40㎛ and a back layer having a thickness of 4.0㎛ was formed from four kinds of solutions containing the yellow pigment (Yellow 10G, Hyundai Chemical), the red pigment (Red-FRN, Hyundai Chemical), the green pigment (Green 735, Hyundai Chemical), and the white pigment (R-100, KPI) among the solutions for forming the print layer by 4-times printing using a gravure roll. The obtained deposition film was evaluated by the above-mentioned methods, and the results were shown in the following Tables 1 and 2.

<Example 16>

A deposition film according to the present invention was manufactured by the same method as in Example 1 except that a thickness of a heat-shrinkable film was 55㎛ and a back layer having a thickness of 0.5㎛ was formed from the solution containing the white pigment (R-100, KPI) among the solutions for forming the print layer by 1-times printing using a gravure roll. The obtained deposition film was evaluated by the above-mentioned methods, and the results were shown in the following Tables 1 and 2.

<Example 17>

A deposition film according to the present invention was manufactured by the same method as in Example 1 except that a back layer was formed using an embossing roll.

At the time of forming the back layer, an embossing structure was formed on the back layer by passing the heat-shrinkable film between a roller having a flat surface and an emboss roll having an embossing structure having a height of 100㎛ at an embossing pressure of 15Kg/cm$^2$.

The obtained deposition film was evaluated by the above-mentioned methods, and the results were shown in the following Tables 1 and 2.

<Example 18>

A deposition film according to the present invention was manufactured by the same method as in Example 1 except that a print layer was formed after a primer layer was formed on a metal deposition layer, and the protective layer coating was not performed.

The primer layer having a thickness of 0.7㎛ was formed on the metal deposition layer by diluting a silane coupling agent (3-glycidoxypropyltrimethoxy silane) with methylethylketone at a concentration of 0.5% using a gravure roll.

The obtained deposition film was evaluated by the above-mentioned methods, and the results were shown in the following Tables 1 and 2.

<Example 19>

A coating solution having a solid content of 25 weight% was prepared by diluting a mixed varnish composed of 10 weight% of urethane (urethane varnish) and 90 weight% of vinyl chloride (vinyl chloride varnish) with methylethylketone (MEK) and used on the metal deposition layer of Example 18 using a gravure roll. A deposition film according to the present invention was manufactured by the same method as in Example 18 except that a primer layer having a thickness of 0.7$\mu$m was formed using this coating solution. The obtained deposition film was evaluated by the above-mentioned methods, and the results were shown in the following Tables 1 and 2.

<Example 20>

A deposition film according to the present invention was manufactured by forming a metal deposition layer, a print layer, a protective layer, and a back layer by the same method as in Example 1 except that a biaxial heat-shrinkable polyester film having a shrinkage rate of 30.2% in a machine direction (MD) of the film, a shrinkage rate of 74.5% in a transverse direction (TD), and a thickness of 50$\mu$m was manufactured by passing an unstretched film obtained by the same method as in Example 1 through a preheating section at 70 °C, stretching the preheated film 1.5 times at 75°C in the machine direction, passing the stretched film through a cooling roll at room temperature to cool the film at the time of passing film through a roller group transferred in the machine direction, and then continuously stretching the film in a tenter in the transverse direction under the same conditions as those in Example 1.

The obtained deposition film was evaluated by the above-mentioned methods, and the results were shown in the following Tables 1 and 2.

<Example 21>

A deposition film according to the present invention was manufactured by forming a metal deposition layer, a print layer, a protective layer, and a back layer by the same method as in Example 20 except that a biaxial heat-shrinkable polyester film having a shrinkage rate of 53.2% in a machine direction (MD) of the film, a shrinkage rate of 65.2% in a transverse direction (TD), and a thickness of 50$\mu$m was manufactured by passing an unstretched film obtained by the method in Example 1 through a preheating section at 75°C, stretching the preheated film 3.0 times at 82°C in the machine direction of the film, passing the stretched film through a cooling roll at room temperature to cool the film at the time of passing film through a roller group transferred in the machine direction, and then continuously stretching the film in a tenter in the transverse direction under the same conditions as those in Example 1.

The obtained deposition film was evaluated by the above-mentioned methods, and the results were shown in the following Tables 1 and 2.

<Example 22>

A deposition film according to the present invention was manufactured by the same method as in Example 1 except that an aluminum metal deposition layer having an optical density (OD) of 0.65 was formed on a polyester-based heat-shrinkable film by depositing aluminum having a purity of 99.9% using a boat type evaporator under conditions at which a degree of vacuum at an upper portion of the evaporator was $0.5\times 10^{-2}$mbar, a degree of vacuum at a lower portion was $1.2\times 10^{-4}$mbar, a cooling roll temperature was -11°C, and a deposition rate was 550m/min. The obtained deposition film was evaluated by the above-mentioned methods, and the results were shown in the following Tables 1 and 2.

<Example 23>

A deposition film according to the present invention was manufactured by the same method as in Example 1 except that a back layer having a thickness of 6.0$\mu$m was formed from seven kinds of solutions containing the yellow pigment (Yellow 10G, Hyundai Chemical), the red pigment (Red-FRN, Hyundai Chemical), the green pigment (Green 735, Hyundai Chemical), the blue pigment (Blue 501, Hyundai Chemical), the pink pigment (Pink E, Hyundai Chemical), the brown pigment (Brown HFR, Hyundai Chemical), and the white pigment (R-100, KPI) among the solutions for forming the print layer of Example 10 by 7-times printing using a gravure roll. The obtained deposition film was evaluated by the above-mentioned methods, and the results were shown in the following Tables 1 and 2.

<Example 24>

Polycondensation was performed by a direct esterification method using 100 mole% of terephthalic acid as a dibasic acid component, 108 mole% of ethylene glycol and 16 mole% of neopentyl glycol as glycol components, and antimony trioxide (0.05mole based on an acid component) as a catalyst. Silicon dioxide powder (500ppm) having an average particle size of 2.7$\mu$m was added to the obtained polymer and dried by a method according to the related art, thereby preparing copolyester having an inherent viscosity of 0.73dℓ/g and a melting point of 210°C.

85 weight% of the copolyester and 15 weight% of polybutylene terephthalate in Example 1 were blended with each other and extruded using an extruder at 270°C, followed by rapid cooling and solidification, thereby obtaining an unstretched film. The unstretched film passed through a roller transferred in a machine direction and a preheating section at 92°C and was stretched 3.8 times at 85°C in a transverse direction. Then, the stretched film passed through a heat treating section at 97°C, thereby manufacturing a heat-shrinkable film having a thickness of 50$\mu$m.

A deposition film according to the present invention was manufactured by the same method as in Example 1 except that after forming a metal deposition, a print layer, and a protective layer on the obtained polyester-based heat-shrinkable film under the same conditions as those in Example 1, a back layer having a thickness of 3.0$\mu$m was formed from three kinds of solutions containing the yellow pigment (Yellow 10G, Hyundai Chemical), the red pigment (Red-FRN, Hyundai Chemical), and the white pigment (R-100, KPI) among the solutions for forming the print layer by 3-times printing using a gravure roll. The obtained deposition film was evaluated by the above-mentioned methods, and the results were shown in the following Tables 1 and 2.

<Example 25>

A deposition film according to the present invention was manufactured by the same method as in Example 1 except that an unstretched film was manufactured by melt-mixing the polybutylene terephthalate of Example 1 and titanium dioxide particles (particle size: 0.3$\mu$m) using a twin screw extruder to prepare a master batch chip having a titanium dioxide content of 50 weight% and blending 95 weight% of the copolyester of Example 1 and 5 weight% of the master batch chip with each other, and a back layer was not processed. The obtained deposition film was evaluated by the above-mentioned methods, and the results were shown in the following Tables 1 and 2.

<Example 26>

A deposition film according to the present invention was manufactured by the same method as in Example 1 except that a protective layer was not formed on the print layer. The obtained deposition film was evaluated by the above-mentioned methods, and the results were shown in the following Tables 1 and 2.

<Reference Example 1>

A deposition film according to the present invention was manufactured by the same method as in Example 1 except that a thickness of a heat-shrinkable film was 30$\mu$m and a back layer having a thickness of 0.5$\mu$m was formed from the solution containing the white pigment (R-100, KPI) among the solutions for forming the print layer by 1-times printing using a gravure roll. The obtained deposition film was evaluated by the above-mentioned methods, and the results were shown in the following Tables 1 and 2.

[Table 1]

| | Base film | | Optical density (OD) of metal deposition layer |
|---|---|---|---|
| | Heat shrinkage rate (Maximum shrinkage direction; TD,%) | Haze (%) | |
| Example 1 | 76.5 | 5.7 | 2.43 |
| Example 2 | 42.5 | 8.8 | 2.35 |
| Example 3 | 78.6 | 0.3 | 2.53 |
| Example 4 | 79.5 | 3.5 | 2.25 |
| Example 5 | 62.5 | 6.3 | 2.43 |
| Example 6 | 65.8 | 5.5 | 1.13 |
| Example 7 | 78.7 | 6.1 | 3.37 |
| Example 8 | 70.3 | 5.4 | 2.43 |
| Example 9 | 69.5 | 5.1 | 2.43 |

(continued)

| | Base film | | Optical density (OD) of metal deposition layer |
|---|---|---|---|
| | Heat shrinkage rate (Maximum shrinkage direction; TD,%) | Haze (%) | |
| Example 10 | 70.3 | 5.4 | 2.43 |
| Example 11 | 76.5 | 5.7 | 2.43 |
| Example 12 | 76.5 | 5.7 | 2.43 |
| Example 13 | 76.5 | 5.7 | 2.43 |
| Example 14 | 76.5 | 5.7 | 2.43 |
| Example 15 | 75.8 | 4.6 | 2.43 |
| Example 16 | 76.9 | 6.3 | 2.43 |
| Example 17 | 76.5 | 5.7 | 2.43 |
| Example 18 | 76.5 | 5.7 | 2.43 |
| Example 19 | 76.5 | 5.7 | 2.43 |
| Example 20 | 74.5 | 5.8 | 2.43 |
| Example 21 | 65.2 | 6.3 | 2.43 |
| Example 22 | 76.5 | 5.7 | 0.65 |
| Example 23 | 76.5 | 5.7 | 2.43 |
| Example 24 | 39.0 | 4.5 | 2.43 |
| Example 25 | 77.1 | 42.8 | 2.71 |
| Example 26 | 76.5 | 5.7 | 2.43 |
| Reference Example 1 | 76.5 | 3.5 | 2.43 |

[Table 2]

| | Deposition film | | | | | | | | | |
|---|---|---|---|---|---|---|---|---|---|---|
| | Analysis by thermal stress tester | | | Heat shrinkage rate (Maximum shrinkage direction; TD, %) | Total transmittance (%) | Curl characteristic value (mm) | Stiffness (g/mm$^2$) | Adhesion property of label (%) | Separation property of label (%) | Process applicability of label (%) |
| | Ts (°C) | $T_{(Smax)}$ (°C) | $S_{max}$ (kg/mm$^2$) | | | | | | | |
| Example 1 | 81.7 | 91.6 | 1. 22 | 76.3 | 0.17 | 0 | 7.49 | 100 | 100 | 100 |
| Example 2 | 93.1 | 109.5 | 0.61 | 42.3 | 0.11 | 0 | 10.48 | 99.5 | 99.5 | 99.0 |
| Example 3 | 69.5 | 82.3 | 1.71 | 78.4 | 1. 41 | 2.4 | 1.85 | 99.5 | 100 | 99.5 |
| Example 4 | 86.3 | 95.2 | 0.82 | 79.0 | 0.28 | 0.3 | 5.42 | 100 | 100 | 100 |
| Example 5 | 87.2 | 98.5 | 0.83 | 61.7 | 0.32 | 0.1 | 4.75 | 100 | 100 | 100 |
| Example 6 | 86.5 | 97.6 | 0.88 | 65.5 | 4.12 | 3.8 | 1.65 | 98.0 | 100 | 98.0 |
| Example 7 | 83.1 | 93.2 | 1.10 | 78.0 | 0.08 | 0 | 8.23 | 100 | 100 | 100 |
| Example 8 | 84.5 | 95.3 | 1.11 | 69.2 | 0.15 | 0 | 84.5 | 100 | 100 | 100 |
| Example 9 | 84.1 | 95.0 | 0.91 | 69.1 | 0.33 | 0 | 74.3 | 100 | 100 | 100 |
| Example 10 | 84.9 | 95.8 | 1.08 | 69.3 | 0.12 | 0 | 12.15 | 97.5 | 100 | 97.5 |
| Example 11 | 82.1 | 92.1 | 1.18 | 75.7 | 0.17 | 0 | 7.83 | 100 | 100 | 100 |
| Example 12 | 81.6 | 91.4 | 1.25 | 76.1 | 0.20 | 0 | 7.54 | 100 | 100 | 100 |
| Example 13 | 82.0 | 81.9 | 1.20 | 76.2 | 0.18 | 0 | 7.72 | 100 | 100 | 100 |
| Example 14 | 81.9 | 92.0 | 1.18 | 76.1 | 0.16 | 0 | 7.54 | 100 | 100 | 100 |
| Example 15 | 82.4 | 93.2 | 1.15 | 75.3 | 1.03 | 0.5 | 3.24 | 100 | 100 | 100 |
| Example 16 | 80.9 | 91.1 | 1.33 | 76.3 | 0.23 | 0 | 9.47 | 100 | 100 | 100 |

(continued)

| | Deposition film | | | | | | | | | |
|---|---|---|---|---|---|---|---|---|---|---|
| | Analysis by thermal stress tester | | | Heat shrinkage rate (Maximum shrinkage direction; TD, %) | Total transmittance (%) | Curl characteristic value (mm) | Stiffness ($g/mm^2$) | Adhesion property of label (%) | Separation property of label (%) | Process applicability of label (%) |
| | Ts (°C) | $T_{(Smax)}$ (°C) | $S_{max}$ ($kg/mm^2$) | | | | | | | |
| Example 17 | 80.4 | 90.3 | 1.52 | 76.2 | 0.33 | 0 | 6.15 | 100 | 100 | 100 |
| Example 18 | 81.8 | 92.1 | 1.21 | 76.2 | 0.19 | 0 | 7.53 | 100 | 100 | 100 |
| Example 19 | 81.9 | 91.9 | 1.24 | 76.3 | 0.19 | 0 | 7.58 | 100 | 100 | 100 |
| Example 20 | 82.9 | 93.1 | 1.15 | 71.3 | 0.17 | 0 | 8.35 | 100 | 100 | 100 |
| Example 21 | 88.9 | 100.6 | 0.79 | 60.3 | 0.16 | 0 | 8.93 | 100 | 100 | 100 |
| Example 22 | 81.8 | 91.7 | 1.25 | 76.2 | 6.85 | 0 | 7.12 | 100 | 100 | 100 |
| Example 23 | 82.3 | 92.1 | 1.18 | 76.0 | 0.16 | 5.2 | 13.2 | 91.0 | 100 | 91.0 |
| Example 24 | 95.3 | 114.2 | 0.55 | 38.5 | 0.18 | 0 | 3.75 | 100 | 86.2 | 86.2 |
| Example 25 | 78.5 | 90.2 | 1.47 | 76.3 | 0.35 | 0 | 9.75 | 81.5 | 97.5 | 79.5 |
| Example 26 | 81.6 | 91.8 | 1.21 | 76.2 | 0.18 | 0 | 74.5 | 100 | 100 | 100 |
| Reference Example 1 | 81.3 | 91.2 | 1.32 | 76.2 | 0.31 | 10.3 | 1.37 | 34.5 | 100 | 34.5 |

Examples 8, 9, 23 and 26 are comparative examples.

Among the Examples, in the case of Examples 20 and 21 in which the stretching was performed in both of the machine direction and the transverse direction of the film, the adhesion property and separation property of the label was excellent, such that the process applicability was excellent, and it may be relatively easy to separate the label peeled off and detached from the bottle and the bottle from each other, as compared to other Examples. Particularly, in a floating type bottle washer of introducing water into the bottle washer to float a label on water surface by using pressure of water and collecting a separated label using a hook at an upper portion of the bottle washer, in the cases of other Examples in which the stretching was performed only in the transverse direction of the film, a label curling phenomenon in the maximum shrinkage direction of the film was generated, such that at the time of floating the label to the upper portion of the bottle washer, pressure or a flux of water needs to be increased, but in the cases of Examples 20 and 21, at the time of separating the label from the bottle, a bidirectional shrinkage phenomenon was generated, which alleviates the label curling phenomenon, such that it may be easy to float the label to the upper portion of the bottle washer to separate the label from the bottle, as compared to other Examples. Therefore, the cases of Examples 20 and 21 were advantageous in view of reduction of water and energy consumption.

Among the Examples, in the case of Example 22, since the processability was excellent but the optical density of the metal deposition layer was low, the total transmittance of the heat-shrinkable deposition film was high, such that at the time of applying a print label, which was a final product, to a colored bottle, a color of the bottle was projected, which may deteriorate a printing effect and visibility of the printed pattern, thereby deteriorating an aesthetic property of the advertisement.

Further, in the case of Example 23 in which the thickness of the back layer was thick, since curl generation due to an expansion phenomenon caused by the printing solvent was severe, flatness of the heat-shrinkable deposition film was deteriorated, such that the curl characteristic value was high, and since the film was stiff, the stiffness was high, such that at the time of attaching the label to the bottle, the label was partially separated due to the warpage generation and high stiffness. Therefore, it may be appreciated that the adhesion property was deteriorated.

Furthermore, in the case of Example 24 in which the shrinkage initiation temperature was high and the maximum shrinkage stress was low, at the time of removing the print label from the bottle, the case in which a part of the print label was still attached to the label was generated. In this case, since several processes should be performed at the time of removing the print label, economical efficiency may be deteriorated.

In the case of Example 25 in which the back layer was not formed, at the time of attaching the print label to the bottle, the print label was not fixed to the bottle but slid down the bottle, such that a labeling position was different or a part of the print label was separated from the bottle, thereby deteriorating adhesion stability. In addition, at the time of removing the print label, since a time consumed to infiltrate water between the bottle and the print label was relatively long, at the time of washing the bottle, a time consumed to remove the label may be slightly increased.

In the case of Example 26 to which the protective layer or primer layer was not applied, there was no problem in the adhesion property and separation property, but the metal deposition layer and the print layer of the print label were separated from each other at the time of separating the print label, such that the print label separating material may contaminate the water, which may cause secondary contamination of the bottle. As a result, additional washing of the bottle should be performed. There was no problem in the entire processability, but since the washing process of the bottle should be added after separating the print label, at the time of applying the print label, process cost may be increased.

In the case of the Reference Example 1 in which the stiffness of the heat-shrinkable deposition film was excessively low, it may be appreciated that at the time of attaching the print label, since a phenomenon that the print label was partially folded was frequently generated, the print label was attached to the bottle in a state in which the print label was partially folded, such that adhesion failure was frequently generated, feeding of the print label may be difficult, and production processability was deteriorated.

Therefore, it may be appreciated that the polyester-based metalizing film according to the present invention, including the heat-shrinkable polyester-based film base; the metal deposition layer on the base; and the print layer on the metal deposition layer, and having a stiffness of 1.5g/mm$^2$ in the maximum shrinkage direction has easy processability in the on-line adhesion process at the time of being used as the label, and when the polyester-based metalizing film was treated with hot water preferably at 90°C for 10 seconds, in the case in which the shrinkage ratio in the maximum shrinkage direction was 40 to 80%, the shrinkage initiation temperature in the maximum shrinkage direction was 68 to 94°C, the maximum shrinkage temperature was 80 to 110°C, the maximum shrinkage stress was 0.60 to 1.80kg/mm$^2$, the total transmittance was 0.01 to 5%, and the curl characteristic value was 5mm or less, processability, a print appearance, the adhesion property, and the separation property were excellent.

<Example 27>

Polycondensation was performed by a direct esterification method using 100 mole% of terephthalic acid as a dibasic acid component, 100 mole% of ethylene glycol and 24 mole% of neopentyl glycol as glycol components, and antimony trioxide (0.05mole based on an acid component) as a catalyst. Silicon dioxide powder (500ppm) having an average particle size of 2.7μm was added to the obtained polymer and dried by a method according to the related art, thereby obtaining copolyester having an inherent viscosity of 0.71dℓ/g and a melting point of 203°C.

Meanwhile, a polybutylene terephthalate resin (inherent viscosity: 0.97dℓ/g, melting point: 220°C) was obtained using 100 mole% of terephthalic acid and 100 mole% of 1,4-butadiene by injecting 0.015 parts by weight of tetrabutyl titanate as a catalyst.

90 weight% of the copolyester and 10 weight% of polybutylene terephthalate were blended with each other and extruded using an extruder at 270°C, followed by rapid cooling and solidification, thereby obtaining an unstretched film. The unstretched film passed through a roller transferred in a machine direction and a preheating section at 85°C and was stretched 4.2 times at 72°C in a transverse direction. Then, the stretched film passed through a heat treating section at room temperature, thereby manufacturing a film. The obtained film had a thickness of 50μm, and a heat shrinkage rate and a haze measured by the methods as described above were 77.4% (TD direction) and 5.3%, respectively.

A metal (aluminum) deposition layer (thickness: 52nm) was formed on the obtained polyester-based heat-shrinkable film by depositing aluminum having a purity of 99.9% using a boat type evaporator under conditions at which a degree of vacuum at an upper portion of the evaporator was $2.3\times 10^{-2}$mbar, a degree of vacuum at a lower portion was $5.7\times 10^{-4}$mbar, a cooling roll temperature was - 15°C, and a deposition rate was 405m/min.

A print layer having a thickness of 2μm was formed on the metal deposition layer from five kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a yellow pigment (Yellow 10G, Hyundai Chemical), a red pigment (Red-FRN, Hyundai Chemical), a green pigment (Green 735, Hyundai Chemical), a black pigment (Black #30, Hyundai Chemical), and a white pigment (R-100, KPI) to have the entire content of 100 weight% by 5-times printing using a gravure roll.

A coating solution having a solid content of 25 weight% was prepared by diluting a mixed varnish composed of 10 weight% of urethane (urethane varnish) and 90 weight% of vinyl chloride (vinyl chloride varnish) with methylethylketone (MEK) and used on the print layer using a gravure roll. A protective layer (thickness: 0.4μm) was formed using this coating solution.

Meanwhile, a back layer having a thickness of 1.5μm was formed from the solution containing 10 weight% of the acrylic resin (BPS-5968, Samyoung Toyo), 80 weight% of methylethylketone, and 10 weight% of the white pigment (R-100, KPI) among the solutions for forming the print layer by 1-times printing using a gravure roll, thereby manufacturing a deposition film according to the present invention.

The obtained deposition film was evaluated by the above-mentioned methods, and the results were shown in the following Tables 3 and 4.

<Example 28>

Polycondensation was performed by a direct esterification method using 100 mole% of terephthalic acid as a dibasic acid component, 106 mole% of ethylene glycol and 18 mole% of neopentyl glycol as glycol components, and antimony trioxide (0.05mole based on an acid component) as a catalyst. Silicon dioxide powder (500ppm) having an average particle size of 2.7μm was added to the obtained polymer and dried by a method according to the related art, thereby preparing copolyester having an inherent viscosity of 0.63dℓ/g and a melting point of 218°C.

90 weight% of the copolyester and 10 weight% of polybutylene terephthalate in Example 27 were blended with each other and extruded using an extruder at 270°C, followed by rapid cooling and solidification, thereby obtaining an unstretched film. The unstretched film passed through a roller transferred in a machine direction and a preheating section at 92°C and was stretched 4.0 times at 72°C in a transverse direction. Then, the stretched film passed through a heat treating section at 90°C, thereby manufacturing a heat-shrinkable film having a thickness of 60μm.

The same processes as those in Example 27 were performed on the obtained polyester-based heat-shrinkable film under the same conditions, thereby manufacturing a deposition film according to the present invention, including a metal deposition layer having a thickness of 52nm, a print layer having a thickness of 2μm, a protective layer having a thickness of 0.4μm, and a back layer having a thickness of 1.5μm.

The obtained deposition film was evaluated by the above-mentioned methods, and the results were shown in the following Tables 3 and 4.

<Example 29>

Polycondensation was performed by a direct esterification method using 100 mole% of terephthalic acid as a dibasic acid component, 96 mole% of ethylene glycol and 28 mole% of neopentyl glycol as glycol components, and antimony trioxide (0.05mole based on an acid component) as a catalyst. Silicon dioxide powder (50ppm) having an average particle size of 2.7$\mu$m was added to the obtained polymer and dried by a method according to the related art, thereby preparing copolyester having an inherent viscosity of 0.73dℓ/g and a melting point of 193°C.

90 weight% of the copolyester and 10 weight% of polybutylene terephthalate in Example 27 were blended with each other and extruded using an extruder at 270°C, followed by rapid cooling and solidification, thereby obtaining an unstretched film. The unstretched film passed through a roller transferred in a machine direction and a preheating section at 82°C and was stretched 4.0 times at 70°C in a transverse direction. Then, the stretched film passed through a heat treating section at room temperature, thereby manufacturing a heat-shrinkable film having a thickness of 40$\mu$m.

The same processes as those in Example 27 were performed on the obtained polyester-based heat-shrinkable film under the same conditions, thereby manufacturing a deposition film according to the present invention, including a metal deposition layer having a thickness of 52nm, a print layer having a thickness of 2$\mu$m, a protective layer having a thickness of 0.4$\mu$m, and a back layer having a thickness of 1.5$\mu$m.

The obtained deposition film was evaluated by the above-mentioned methods, and the results were shown in the following Tables 3 and 4.

<Example 30>

Polycondensation was performed by a direct esterification method using 100 mole% of terephthalic acid as a dibasic acid component, 80 mole% of ethylene glycol and 20 mole% of 1.4-cyclohexane dimethanol as glycol components, and antimony trioxide (0.05mole based on an acid component) as a catalyst. Silicon dioxide powder (500ppm) having an average particle size of 2.7$\mu$m was added to the obtained polymer and dried by a method according to the related art, thereby preparing copolyester having an inherent viscosity of 0.68dℓ/g and a melting point of 205°C.

The copolyester was extruded at 270°C using an extruder, followed by rapid cooling and solidification, thereby obtaining an unstretched film. The unstretched film passed through a roller transferred in a machine direction and a preheating section at 85°C and was stretched 4.2 times at 72°C in a transverse direction. Then, the stretched film passed through a heat treating section at room temperature, thereby manufacturing a heat-shrinkable film having a thickness of 50$\mu$m.

The same processes as those in Example 27 were performed on the obtained polyester-based heat-shrinkable film under the same conditions, thereby manufacturing a deposition film according to the present invention, including a metal deposition layer having a thickness of 52nm, a print layer having a thickness of 2$\mu$m, a protective layer having a thickness of 0.4$\mu$m, and a back layer having a thickness of 1.5$\mu$m.

The obtained deposition film was evaluated by the above-mentioned methods, and the results were shown in the following Tables 3 and 4.

<Example 31>

Polycondensation was performed by a direct esterification method using 100 mole% of terephthalic acid as a dibasic acid component, 100 mole% of ethylene glycol and 24 mole% of neopentyl glycol as glycol components, and antimony trioxide (0.05mole based on an acid component) as a catalyst. Silicon dioxide powder (500ppm) having an average particle size of 2.7$\mu$m was added to the obtained polymer and dried by a method according to the related art, thereby obtaining copolyester having an inherent viscosity of 0.71dℓ/g and a melting point of 203°C.

The copolyester was extruded at 270°C using an extruder, followed by rapid cooling and solidification, thereby obtaining an unstretched film. The unstretched film passed through a roller transferred in a machine direction and a preheating section at 90°C and was stretched 4.0 times at 72°C in a transverse direction. Then, the stretched film passed through a heat treating section at 88 °C, thereby manufacturing a heat-shrinkable film having a thickness of 50$\mu$m.

The same processes as those in Example 27 were performed on the obtained polyester-based heat-shrinkable film under the same conditions, thereby manufacturing a deposition film according to the present invention, including a metal deposition layer having a thickness of 52nm, a print layer having a thickness of 2$\mu$m, a protective layer having a thickness of 0.4$\mu$m, and a back layer having a thickness of 1.5$\mu$m.

The obtained deposition film was evaluated by the above-mentioned methods, and the results were shown in the following Tables 3 and 4.

<Example 32>

A heat-shrinkable film was manufactured by the same method as in Example 27 except that the film passed through a roller transferred in a machine direction and a preheating section at 90°C and was stretched 4.2 times at 72°C in a transverse direction, followed by passing through a heat treating section at 88 °C, thereby manufacturing a film having a thickness of 50$\mu$m.

A metal (aluminum) deposition layer (thickness: 32nm) was formed on the obtained polyester-based heat-shrinkable film by depositing aluminum having a purity of 99.9% using a boat type evaporator under conditions at which a degree of vacuum at an upper portion of the evaporator was $1.0\times 10^{-2}$mbar, a degree of vacuum at a lower portion was $3.5\times 10^{-4}$mbar, a cooling roll temperature was - 15°C, and a deposition rate was 490m/min.
The same processes as those in Example 1 were performed on the metal deposition layer under the same conditions, thereby manufacturing a deposition film according to the present invention, including a print layer having a thickness of 2$\mu$m, a protective layer having a thickness of 0.4$\mu$m, and a back layer having a thickness of 1.5$\mu$m.
The obtained deposition film was evaluated by the above-mentioned methods, and the results were shown in the following Tables 3 and 4.

<Example 33>

A heat-shrinkable film was manufactured by the same method as in Example 27 except that the film passed through a roller transferred in a machine direction and a preheating section at 82°C and was stretched 4.2 times at 72°C in a transverse direction, followed by passing through a heat treating section at room temperature, thereby manufacturing a film having a thickness of 50$\mu$m.
A metal (aluminum) deposition layer (thickness: 85nm) was formed on the obtained polyester-based heat-shrinkable film by depositing aluminum having a purity of 99.9% using a boat type evaporator under conditions at which a degree of vacuum at an upper portion of the evaporator was $3.5\times 10^{-2}$mbar, a degree of vacuum at a lower portion was $8.1\times 10^{-4}$mbar, a cooling roll temperature was - 20°C, and a deposition rate was 315m/min.
The same processes as those in Example 1 were performed on the metal deposition layer under the same conditions, thereby manufacturing a deposition film according to the present invention, including a print layer having a thickness of 2$\mu$m, a protective layer having a thickness of 0.4$\mu$m, and a back layer having a thickness of 1.5$\mu$m.
The obtained deposition film was evaluated by the above-mentioned methods, and the results were shown in the following Tables 3 and 4.

<Example 34>

A deposition film according to the present invention was manufactured by forming a protective layer and a back layer under the same conditions as those in Example 27 except that a print layer having a thickness of 3.5$\mu$m was formed on the metal deposition layer of Example 27 from eight kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a yellow pigment (Yellow 10G, Hyundai Chemical), a red pigment (Red-FRN, Hyundai Chemical), a green pigment (Green 735, Hyundai Chemical), a black pigment (Black #30, Hyundai Chemical), a blue pigment (Blue 501, Hyundai Chemical), a pink pigment (Pink E, Hyundai Chemical), a brown pigment (Brown HFR, Hyundai Chemical), and a white pigment (R-100, KPI) to have the entire content of 100 weight% by 8-times printing using a gravure roll.
The obtained deposition film was evaluated by the above-mentioned methods, and the results were shown in the following Tables 3 and 4.

<Example 35>

A heat-shrinkable film was manufactured by the same method as in Example 27 except that the film passed through a roller transferred in a machine direction and a preheating section at 80°C and was stretched 4.2 times at 70°C in a transverse direction, followed by passing through a heat treating section at room temperature, thereby manufacturing a film having a thickness of 50$\mu$m.
A metal deposition layer having a thickness of 52nm was formed on the obtained polyester-based heat-shrinkable film under the same conditions as those in Example 1.
A print layer having a thickness of 1.0$\mu$m was formed on the metal deposition layer from three kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a red pigment (Red-FRN, Hyundai Chemical), a green pigment (Green 735, Hyundai Chemical), and a white pigment (R-100, KPI) to have the entire content of 100 weight% by 3-times printing using a gravure roll.
The same processes as those in Example 27 were performed on the print layer under the same conditions, thereby manufacturing a deposition film according to the present invention, including a protective layer having a thickness of 0.4$\mu$m and a back layer having a thickness of 1.5$\mu$m.
The obtained deposition film was evaluated by the above-mentioned methods, and the results were shown in the following Tables 3 and 4.

<Example 36>

A deposition film according to the present invention was manufactured by the same method as in Example 27 except that a print layer having a thickness of 8.0$\mu$m was formed on the metal deposition layer from eight kinds of solutions containing 10 weight% of an acrylic resin (BPS-5698, Samyoung Toyo), 80 weight% of methylethylketone (MEK, Daesin Chemicals) as a ketone-based solvent, and 10 weight% of one pigment selected from a yellow pigment (Yellow 10G, Hyundai Chemical), a red pigment (Red-FRN, Hyundai Chemical), a green pigment (Green 735, Hyundai Chemical), a black pigment (Black #30, Hyundai Chemical), a blue pigment (Blue 501, Hyundai Chemical), a pink pigment (Pink E, Hyundai Chemical), a brown pigment (Brown HFR, Hyundai Chemical), and a white pigment (R-100, KPI) to have the entire content of 100 weight% by 8-times printing using a gravure roll.
The obtained deposition film was evaluated by the above-mentioned methods, and the results were shown in the following Tables 3 and 4.

<Example 37>

A coating solution having a solid content of 25 weight% was prepared by diluting a mixed varnish composed of 10 weight% of urethane (urethane varnish) and 90 weight% of vinyl chloride (vinyl chloride varnish) with methylethylketone (MEK) and used on the print layer of Example 27 using a gravure roll. A deposition film according to the present invention was manufactured by the same method as in Example 27 except that a protective layer having a thickness of 2.5$\mu$m was formed using this coating solution.
The obtained deposition film was evaluated by the above-mentioned methods, and the results were shown in the following Tables 3 and 4.

<Example 38>

A coating solution having a solid content of 25 weight% was prepared by diluting a mixed varnish composed of 90 weight% of an acrylic copolymer (vinyl acetate-acrylic varnish) and 10 weight% of a styrene copolymer (styrene-vinyl varnish) with methylethylketone (MEK) and used on the print layer of Example 27 using a gravure roll. A deposition film according to the present invention was manufactured by the same method as in Example 27 except that a protective layer having a thickness of 2.0$\mu$m was formed using this coating solution.
The obtained deposition film was evaluated by the above-mentioned methods, and the results were shown in the following Tables 3 and 4.

<Example 39>

A coating solution having a solid content of 25 weight% was prepared by diluting a copolyester resin (a copolyester resin prepared by mixing at least two kinds of polyol and polybasic acids and having a number average molecular weight of 5000) with methylethylketone (MEK) and used on the print layer of Example 27 using a gravure roll. A deposition film according to the present invention was manufactured by the same method as in Example 27 except that a protective layer having a thickness of 3.5$\mu$m instead of 1.5$\mu$m was formed using this coating solution.
The obtained deposition film was evaluated by the above-mentioned methods, and the results were shown in the following Tables 3 and 4.

<Example 40>

A deposition film according to the present invention was manufactured by the same method as in Example 27 except that a back layer having a thickness of 3.0$\mu$m was formed from two kinds of solutions containing the yellow pigment (Yellow 10G, Hyundai Chemical) and the white pigment (R-100, KPI) among the solutions for forming the print layer by 2-times printing using a gravure roll.
The obtained deposition film was evaluated by the above-mentioned methods, and the results were shown in the following Tables 3 and 4.

<Example 41>

A deposition film according to the present invention was manufactured by the same method as in Example 27 except that a thickness of a heat-shrinkable film was 40$\mu$m and a back layer having a thickness of 3.5$\mu$m was formed from three kinds of solutions containing the yellow pigment (Yellow 10G, Hyundai Chemical), the red pigment (Red-FRN, Hyundai Chemical), and the white pigment (R-100, KPI) among the solutions for forming the print layer by 3-times printing using a gravure roll.

The obtained deposition film was evaluated by the above-mentioned methods, and the results were shown in the following Tables 3 and 4.

<Example 42>

A deposition film according to the present invention was manufactured by the same method as in Example 27 except that a thickness of a heat-shrinkable film was 55$\mu$m and a back layer having a thickness of 0.7$\mu$m was formed from the solution containing the white pigment (R-100, KPI) among the solutions for forming the print layer by 1-times printing using a gravure roll.

The obtained deposition film was evaluated by the above-mentioned methods, and the results were shown in the following Tables 3 and 4.

<Example 43>

A deposition film according to the present invention was manufactured by the same method as in Example 27 except that a back layer was formed using an embossing roll.

More specifically, at the time of forming the back layer, an embossing structure was formed in the back layer by passing the heat-shrinkable film between a roller having a flat surface and an emboss roll having an embossing structure having a height of 50$\mu$m at an embossing pressure of 20Kg/cm$^2$.

The obtained deposition film was evaluated by the above-mentioned methods, and the results were shown in the following Tables 3 and 4.

<Example 44>

A deposition film according to the present invention was manufactured by the same method as in Example 27 except that a print layer was formed after a primer layer was formed on a metal deposition layer, and the protective layer coating was not performed.

More specifically, the primer layer having a thickness of 0.4$\mu$m was formed on the metal deposition layer by diluting a silane coupling agent (3-glycidoxypropyltrimethoxy silane) with methylethylketone at a concentration of 0.5% using a gravure roll.

The obtained deposition film was evaluated by the above-mentioned methods, and the results were shown in the following Tables 3 and 4.

<Example 45>

A coating solution having a solid content of 25 weight% was prepared by diluting a mixed varnish composed of 10 weight% of urethane (urethane varnish) and 90 weight% of vinyl chloride (vinyl chloride varnish) with methylethylketone (MEK) and used on the print layer of Example 44 using a gravure roll. A deposition film according to the present invention was manufactured by the same method as in Example 44 except that a protective layer having a thickness of 0.4$\mu$m was formed using this coating solution.

The obtained deposition film was evaluated by the above-mentioned methods, and the results were shown in the following Tables 3 and 4.

<Example 46>

A deposition film according to the present invention was manufactured by forming a metal deposition layer, a print layer, a protective layer, and a back layer by the same method as in Example 27 except that a biaxial heat-shrinkable polyester film having a shrinkage rate of 37.3% in a machine direction (MD) of the film, a shrinkage rate of 74.9% in a transverse direction (TD), and a thickness of 50$\mu$m was manufactured by passing an unstretched film obtained by the method in Example 27 through a preheating section at 65°C, stretching the preheated film 1.6 times at 70°C in the machine direction of the film, passing the stretched film through a cooling roll at room temperature to cool the film at the time of passing film through a roller group transferred in the machine direction, and then continuously stretching the film using a tenter in the transverse direction under the same conditions as those in Example 27.

The obtained deposition film was evaluated by the above-mentioned methods, and the results were shown in the following Tables 3 and 4.

<Example 47>

A deposition film according to the present invention was manufactured by forming a metal deposition layer, a print layer, a protective layer, and a back layer by the same method as in Example 46 except that a biaxial heat-shrinkable polyester film having a shrinkage rate of 45.8% in a machine direction (MD) of the film, a shrinkage rate of 70.5% in a transverse direction (TD), and a thickness of 50$\mu$m was manufactured by passing an unstretched film through a preheating section at 75°C, stretching the preheated film 2.5 times at 75°C in the machine direction, passing the stretched film through a cooling roll at room temperature to cool the film at the time of passing film through a roller group transferred in the machine direction, and then continuously stretching the film in a tenter in the transverse direction under the same conditions as those in Example 1.

The obtained deposition film was evaluated by the above-mentioned methods, and the results were shown in the following Tables 3 and 4.

<Example 48>

A deposition film according to the present invention was manufactured by the same method in Example 27 except that a metal deposition layer having a thickness of 10nm was formed on a polyester-based heat-shrinkable film by depositing aluminum having a purity of 99.9% using a boat type evaporator under conditions at which a degree of vacuum at an upper portion of the evaporator was $0.4\times 10^{-2}$ mbar, a degree of vacuum at a lower portion was $10\times 10^{-4}$ mbar, a cooling role temperature was -10°C, and a deposition rate was 500m/min. The obtained deposition film was evaluated by the above-mentioned methods, and the results were shown in the following Tables 3 and 4.

<Example 49>

A deposition film according to the present invention was manufactured by the same method as in Example 27 except that a back layer having a thickness of 5.5$\mu$m was formed from five kinds of solutions containing the yellow pigment (Yellow 10G, Hyundai Chemical), the red pigment (Red-FRN, Hyundai Chemical), the green pigment (Green 735, Hyundai Chemical), the black pigment (Black #30, Hyundai Chemical), and a white pigment (R-100, KPI) among the solutions for forming the print layer of Example 36 by 5-times printing using a gravure roll.

The obtained deposition film was evaluated by the above-mentioned methods, and the results were shown in the following Tables 3 and 4.

<Example 50>

Polycondensation was performed by a direct esterification method using 100 mole% of terephthalic acid as a dibasic acid component, 110 mole% of ethylene glycol and 14 mole% of neopentyl glycol as glycol components, and antimony trioxide (0.05mole based on an acid component) as a catalyst. Silicon dioxide powder (500ppm) having an average particle size of 2.7$\mu$m was added to the obtained polymer and dried by a method according to the related art, thereby obtaining copolyester having an inherent viscosity of 0.71dℓ/g and a melting point of 203°C.

90 weight% of the copolyester and 10 weight% of polybutylene terephthalate of Example 27 were blended with each other and extruded using an extruder at 270°C, followed by rapid cooling and solidification, thereby obtaining an unstretched film. The unstretched film passed through a roller transferred in a machine direction and a preheating section at 92°C and was stretched 4.0 times at 80°C in a transverse direction. Then, the stretched film passed through a heat treating section at 95°C, thereby manufacturing a heat-shrinkable film having a thickness of 50$\mu$m.

A deposition film according to the present invention was manufactured by the same method as in Example 27 except that after forming a metal deposition, a print layer, and a protective layer on the obtained polyester-based heat-shrinkable film under the same conditions as those in Example 27, a back layer having a thickness of 3.0$\mu$m was formed from two kinds of solutions containing the yellow pigment (Yellow 10G, Hyundai Chemical) and the white pigment (R-100, KPI) among the solutions for forming the print layer by 2-times printing using a gravure roll.

The obtained deposition film was evaluated by the above-mentioned methods, and the results were shown in the following Tables 3 and 4.

<Example 51>

A deposition film according to the present invention was manufactured by the same method as in Example 27 except that a protective layer was not formed on the print layer.

The obtained deposition film was evaluated by the above-mentioned methods, and the results were shown in the following Tables 3 and 4.

<Reference Example 2>

A deposition film according to the present invention was manufactured by the same method as in Example 27 except that an unstretched film was manufactured by melt-mixing the polybutylene terephthalate of Example 27 and titanium dioxide particles (particle size: 0.3$\mu$m) using a twin screw extruder to prepare a master batch chip having a titanium dioxide content of 50 weight% and blending 90 weight% of the copolyester of Example 27 and 10 weight% of the master batch chip with each other, and a back layer was not processed.

The obtained deposition film was evaluated by the above-mentioned methods, and the results were shown in the following Tables 3 and 4.

[Table 3]

| | Film base | |
|---|---|---|
| | Heat shrinkage rate (Maximum shrinkage direction; TD,%) | Haze (%) |
| Example 27 | 77.4 | 5.3 |
| Example 28 | 43.0 | 8.6 |
| Example 29 | 78.7 | 0.4 |
| Example 30 | 78.5 | 4.3 |
| Example 31 | 64.5 | 6.5 |
| Example 32 | 67.5 | 6.8 |
| Example 33 | 77.5 | 5.4 |
| Example 34 | 77.4 | 5.3 |
| Example 35 | 78.2 | 5.7 |
| Example 36 | 77.4 | 5.3 |
| Example 37 | 77.4 | 5.3 |
| Example 38 | 77.4 | 5.3 |
| Example 39 | 77.4 | 5.3 |
| Example 40 | 77.4 | 5.3 |
| Example 41 | 76.7 | 4.1 |
| Example 42 | 77.2 | 7.2 |
| Example 43 | 77.4 | 5.3 |
| Example 44 | 77.4 | 5.3 |
| Example 45 | 77.4 | 5.3 |
| Example 46 | 74.9 | 5.9 |
| Example 47 | 70.5 | 6.2 |
| Example 48 | 77.4 | 5.3 |
| Example 49 | 77.4 | 5.3 |
| Example 50 | 38.5 | 6.8 |
| Example 51 | 77.4 | 5.3 |
| Reference Example 2 | 77.4 | 90.2 |

[Table 4]

| | Deposition film | | | | | | | |
|---|---|---|---|---|---|---|---|---|
| | Analysis by thermal stress tester | | | Heat shrinkage rate (Maximum shrinkage direction, TD, %) | Total transmittance (%) | Adhesion property of label (%) | Separation property of label (%) | Process applicability of label (%) |
| | Ts (°C) | T (Smax) (°C) | $S_{max}$ (kg/mm$^2$) | | | | | |
| Example 27 | 82.3 | 91.3 | 1. 23 | 77.2 | 0.20 | 100 | 100 | 100 |
| Example 28 | 92.4 | 108.7 | 0.63 | 42.0 | 0.15 | 99.5 | 99.6 | 99.1 |
| Example 29 | 70.4 | 87.3 | 1.67 | 78.0 | 0.23 | 100 | 100 | 100 |
| Example 30 | 88.2 | 99.7 | 0.67 | 75.3 | 0.20 | 100 | 99.7 | 99.7 |
| Example 31 | 88.1 | 97.9 | 0.86 | 63.2 | 0.20 | 100 | 100 | 100 |
| Example 32 | 87.5 | 97.0 | 0.89 | 65.9 | 3.35 | 100 | 100 | 100 |
| Example 33 | 82.2 | 90.9 | 1.34 | 77.3 | 0.05 | 100 | 100 | 100 |
| Example 34 | 83.5 | 92.4 | 1.20 | 76.2 | 0.18 | 100 | 100 | 100 |
| Example 35 | 78.2 | 89.7 | 1.51 | 77.3 | 0.36 | 100 | 100 | 100 |
| Example 36 | 85.3 | 94.1 | 1.15 | 73.4 | 0.12 | 99.5 | 100 | 99.5 |
| Example 37 | 83.2 | 92.2 | 1.19 | 77.0 | 0.19 | 100 | 100 | 100 |
| Example 38 | 82.1 | 91.6 | 1.20 | 76.8 | 0.19 | 100 | 100 | 100 |

(continued)

| | Deposition film | | | | | | | |
|---|---|---|---|---|---|---|---|---|
| | Analysis by thermal stress tester | | | Heat shrinkage rate (Maximum shrinkage direction, TD, %) | Total transmittance (%) | Adhesion property of label (%) | Separation property of label (%) | Process applicability of label (%) |
| | Ts (°C) | T (Smax) (°C) | $S_{max}$ ($kg/mm^2$) | | | | | |
| Example 39 | 85.3 | 94.2 | 1.10 | 74.1 | 0.18 | 99.5 | 100 | 99.5 |
| Example 40 | 83.4 | 92.3 | 1.17 | 75.5 | 0.15 | 100 | 100 | 100 |
| Example 41 | 85.7 | 93.5 | 1.08 | 72.5 | 0.17 | 99.5 | 100 | 99.5 |
| Example 42 | 81.3 | 90.2 | 1.35 | 77.1 | 0.27 | 100 | 100 | 100 |
| Example 43 | 80.9 | 90.5 | 1.25 | 77.2 | 0.35 | 98.7 | 100 | 98.7 |
| Example 44 | 82.1 | 91.4 | 1. 22 | 77.1 | 0.20 | 100 | 100 | 100 |
| Example 45 | 82.0 | 91.5 | 1.24 | 77.2 | 0.21 | 100 | 100 | 100 |
| Example 46 | 83.2 | 93.5 | 1.18 | 71.7 | 0.20 | 100 | 100 | 100 |
| Example 47 | 84.5 | 95.7 | 1.12 | 68.2 | 0.20 | 100 | 100 | 100 |
| Example 48 | 82.0 | 90.9 | 1.28 | 77.2 | 10.23 | 100 | 100 | 100 |
| Example 49 | 87.2 | 94.3 | 1.02 | 70.2 | 0.12 | 92.5 | 100 | 92.5 |
| Example 50 | 94.3 | 111.9 | 0.52 | 38.1 | 0.15 | 100 | 85.1 | 85.1 |

(continued)

| | Deposition film | | | | | | | |
|---|---|---|---|---|---|---|---|---|
| | Analysis by thermal stress tester | | | Heat shrinkage rate (Maximum shrinkage direction, TD, %) | Total transmittance (%) | Adhesion property of label (%) | Separation property of label (%) | Process applicability of label (%) |
| | Ts (°C) | $T_{(Smax)}$ (°C) | $S_{max}$ ($kg/mm^2$) | | | | | |
| Example 51 | 82.1 | 92.1 | 1.25 | 77.2 | 0.21 | 100 | 100 | 100 |
| Reference Example 2 | 81.7 | 90.8 | 1.33 | 77.1 | 0.30 | 56.3 | 95.5 | 53.8 |

Among the Examples, in the case of Examples 46 and 47 in which the stretching was performed in both of the machine direction and the transverse direction of the film, the adhesion property and separation property of the label were excellent, such that the process applicability was excellent, and it may be relatively easy to separate the label peeled off and detached from the bottle and the bottle from each other, as compared to other Examples. Particularly, in a floating type bottle washer for introducing water into the bottle washer to float a label on water surface by using pressure of water and collecting a separated label using a hook at an upper portion of the bottle washer, in the cases of other Examples in which the stretching was performed only in the transverse direction of the film, a label curling phenomenon in the maximum shrinkage direction of the film was generated, such that at the time of floating the label to the upper portion of the bottle washer, pressure or a flux of water needs to be increased, but in the cases of Examples 46 and 47, at the time of separating the label from the bottle, a bidirectional shrinkage phenomenon was generated, which alleviates the label curling phenomenon, such that it may be easy to float the label to the upper portion of the bottle washer to separate the label from the bottle, as compared to other Examples. Therefore, the cases of Examples 46 and 47 were advantageous in view of reduction of water and energy consumption.

Among the Examples, in the case of Example 48, since the processability was excellent but the thickness of the metal deposition layer was thin, the total transmittance of the heat-shrinkable deposition film was high, such that at the time of applying a print label, which was a final product, to a colored bottle, a color of the bottle was projected, which may deteriorate a printing effect and visibility of the printed pattern, thereby deteriorating an aesthetic property of the advertisement.

It may be appreciated that in the case of Example 49 in which the thickness of the back layer was thick, the heat-shrinkable deposition film was stiff, such that after attaching the print label to the bottle, the label was partially separated, thereby deteriorating the adhesion property.

In the case of Example 50 in which the shrinkage initiation temperature was high and the maximum shrinkage stress was low, at the time of removing the print label from the bottle, the case in which a part of the print label was still attached to the label was generated. In this case, since several processes should be performed at the time of removing the print label, economical efficiency may be deteriorated.

In the case of Example 51 to which the protective layer or primer layer was not applied, there were no problems in the adhesion property and separation property, but the metal deposition layer and the print layer of the print label were separated from each other at the time of separating the print label, such that the print label separating material may contaminate water, which may cause secondary contamination of the bottle. As a result, additional washing of the bottle should be performed. There were no problems in the entire processability, but since the washing process of the bottle should be added after separating the print label, at the time of applying the print label, process cost may be increased.

In the case of the Reference Example 2 in which the back layer was not formed, at the time of attaching the print label to the bottle, the print label was not fixed to the bottle but slid down the bottle, such that a labeling position was different or a part of the print label was frequently separated from the bottle, thereby deteriorating adhesion stability. In addition, at the time of removing the print label, since it was difficult to infiltrate water between the bottle and the print label, processability at the time of removing the print label was partially deteriorated. At the time of removing the print label, since the time consumed to infiltrate water between the bottle and the print label was relatively long, at the time of washing the bottle, the time consumed to remove the label may be slightly increased.

Therefore, among the polyester-based metalizing films according to the present invention, including the heat-shrinkable polyester-based film base; the metal deposition layer on the base; and the print layer on the metal deposition layer, and the back layer on the other surface of the base, when the polyester-based metalizing film was treated with hot water preferably at 90°C for 10 seconds, the polyester-based metalizing film of which the shrinkage ratio in the maximum shrinkage direction was 40 to 80%, the shrinkage initiation temperature in the maximum shrinkage direction was 68 to 94°C, the maximum shrinkage temperature was 80 to 110°C, the maximum shrinkage stress was 0.60 to 1.80kg/$mm^2$, and the total transmittance was 0.01 to 5% may be most preferable. It may be appreciated that in this case, processability, the print appearance, the adhesion property, and the separation property were excellent.

## Claims

**1.** A polyester-based metalizing film comprising:

a heat-shrinkable polyester-based film base;
a metal deposition layer formed on the base; and
a print layer formed on the metal deposition layer, and
a back layer formed on the other surface of the heat-shrinkable polyester-based film as an embossing layer formed by physically or chemically treating a surface of the heat-shrinkable polyester-based film or a white pigment coating layer,

wherein a stiffness of the film in a maximum shrinkage direction is 1.5 to 13 g/mm$^2$, (determined according to the method described herein), and a curl characteristic value defined by a detailed description is 5mm or less.

**2.** The polyester-based metalizing film of claim 1, further comprising a primer layer formed between the metal deposition layer and the print layer.

**3.** The polyester-based metalizing film of claim 1, further comprising a protective layer formed on the print layer, wherein the protective layer is made of any one selected from copolyester, an acrylic copolymer, a styrene copolymer, a methacrylate copolymer, polystyrene, vinyl acetate, polyamide, alkylacrylate, ureaformaldehyde, epoxydized soybean oil, an ethylene-vinyl acetate copolymer, beef tallow-based oleamide, polyethylene glycol distearate, polyvinylidene, a polyolefin-based copolymer, a urethane resin, and a vinyl-based resin, or a mixture thereof.

**4.** The polyester-based metalizing film of claim 2, further comprising a protective layer formed on the print layer, wherein the protective layer is made of any one selected from copolyester, an acrylic copolymer, a styrene copolymer, a methacrylate copolymer, polystyrene, vinyl acetate, polyamide, alkylacrylate, ureaformaldehyde, epoxydized soybean oil, an ethylene-vinyl acetate copolymer, beef tallow-based oleamide, polyethylene glycol distearate, polyvinylidene, a polyolefin-based copolymer, a urethane resin, and a vinyl-based resin, or a mixture thereof.

**5.** The polyester-based metalizing film of claim 1, wherein the heat-shrinkable polyester-based film base has a thickness of 35 to 65$\mu$m.

**6.** The polyester-based metalizing film of claim 1, wherein the metal deposition layer has an optical density of 1.0 to 3.5.

**7.** The polyester-based metalizing film of claim 1, wherein the heat-shrinkable polyester-based film base contains a polyester-based resin including a butylene terephthalate repeating unit.

**8.** The polyester-based metalizing film of claim 1, wherein the heat-shrinkable polyester-based film base contains at least one copolyester selected from copolyesters obtained from dicarboxylic acid component including at least one dicarboxylic acid such as terephthalic acid, oxalic acid, malonic acid, succinic acid, adipic acid, suberic acid, azelaic acid, sebacic acid, phthalic acid, isophthalic acid, naphthalene dicarboxylic acid, diphenyl ether carboxylic acid, and a diol component including at least one diol such as ethylene glycol, neopentyl glycol, propylene glycol, trimethylene glycol, tetramethylene glycol, hexamethylene glycol, diethylene glycol, polyalkylene glycol, 1,4-cyclohexane dimethanol.

**9.** The polyester-based metalizing film of claim 8, wherein in the copolyester, a ratio of a terephthalic acid monomer among the dicarboxylic acid monomers is 80 mole% or more, and a ratio of other monomers except for ethylene glycol among the diol monomers is 12 to 24 mole%.

**10.** The polyester-based metalizing film of claim 1, wherein the heat-shrinkable polyester-based film base is a uniaxially oriented heat-shrinkable polyester-based film base or a biaxially oriented heat-shrinkable polyester-based film base.

**11.** The polyester-based metalizing film of claim 1, wherein in the case in which it is treated with hot water at 90°C for 10 seconds, a shrinkage ratio in the maximum shrinkage direction is 40 to 80%, a shrinkage initiation temperature in the maximum shrinkage direction is 68 to 94°C, a maximum shrinkage temperature is 80 to 110°C, and a maximum shrinkage stress is 0.6 to 1.80kg/mm$^2$.

**12.** The polyester-based metalizing film of claim 1, wherein it has a total transmittance of 0.01 to 5%.

**13.** The polyester-based metalizing film of claim 1, wherein the heat-shrinkage polyester-based film base has a haze of 0.3 to 10%.

**14.** A label-attached bottle comprising the polyester-based metalizing film of claim 1.

**15.** The label-attached bottle of claim 14, wherein the polyester-based metalizing film is removed by immersing the bottle in hot water.

**16.** A label-attached bottle comprising the polyester-based metalizing film of claim 2.

**17.** The label-attached bottle of claim 16, wherein the polyester-based metalizing film is removed by immersing the bottle in hot water.

## Patentansprüche

**1.** Metallisierte Folie auf Polyesterbasis, umfassend:

eine wärmeschrumpfbare Folienbasis auf Polyesterbasis;
eine Metallabscheidungsschicht, die auf der Basis ausgebildet ist; und
eine Druckschicht, die auf der Metallabscheidungsschicht ausgebildet ist, und
eine Rückschicht, die auf der anderen Oberfläche der wärmeschrumpfbaren Folie auf Polyesterbasis als Prägeschicht ausgebildet ist, die durch physische oder chemische Behandlung einer Oberfläche der wärmeschrumpfbaren Folie auf Polyesterbasis geformt wird, oder eine Weißpigmentüberzugsschicht, wobei eine Steifigkeit der Folie in einer maximalen Schrumpfungsrichtung 1,5 bis 13 g/mm$^2$ beträgt (bestimmt nach dem hier beschriebenen Verfahren), und ein durch eine detaillierte Beschreibung definierter charakteristischer Rollneigungswert 5 mm oder weniger beträgt.

**2.** Metallisierte Folie auf Polyesterbasis nach Anspruch 1, ferner umfassend eine zwischen der Metallabscheidungsschicht und der Druckschicht ausgebildete Grundierungsschicht.

**3.** Metallisierte Folie auf Polyesterbasis nach Anspruch 1, ferner umfassend eine auf der Druckschicht ausgebildete Schutzschicht, wobei die Schutzschicht hergestellt ist aus irgendeinem gewählt aus Copolyester, einem Acrylcopolymer, einem Styrolcopolymer, einem Methacrylatcopolymer, Polystyrol, Vinylacetat, Polyamid, Alkylacrylat, Ureaformaldehyd, epoxidiertem Sojabohnenöl, einem Ethylen-Vinylacetat-Copolymer, Oleamid auf Rindertalgbasis, Polyethylenglykoldistearat, Polyvinyliden, einem Copolymer auf Polyolefinbasis, einem Urethanharz und einem Harz auf Vinylbasis oder einer Mischung davon.

**4.** Metallisierte Folie auf Polyesterbasis nach Anspruch 2, ferner umfassend eine auf der Druckschicht ausgebildete Schutzschicht, wobei die Schutzschicht hergestellt ist aus irgendeinem gewählt aus Copolyester, einem Acrylcopolymer, einem Styrolcopolymer, einem Methacrylatcopolymer, Polystyrol, Vinylacetat, Polyamid, Alkylacrylat, Ureaformaldehyd, epoxidiertem Sojabohnenöl, einem Ethylen-Vinylacetat-Copolymer, Oleamid auf Rindertalgbasis, Polyethylenglykoldistearat, Polyvinyliden, einem Copolymer auf Polyolefinbasis, einem Urethanharz und einem Harz auf Vinylbasis oder einer Mischung davon.

**5.** Metallisierte Folie auf Polyesterbasis nach Anspruch 1, wobei die wärmeschrumpfbare Folienbasis auf Polyesterbasis eine Dicke von 35 bis 65 $\mu$m aufweist.

**6.** Metallisierte Folie auf Polyesterbasis nach Anspruch 1, wobei die Metallabscheidungsschicht eine optische Dichte von 1,0 bis 3,5 aufweist.

**7.** Metallisierte Folie auf Polyesterbasis nach Anspruch 1, wobei die wärmeschrumpfbare Folienbasis auf Polyesterbasis ein Harz auf Polyesterbasis enthält, das eine Butylenterephthalatwiederholungseinheit enthält.

**8.** Metallisierte Folie auf Polyesterbasis nach Anspruch 1, wobei die wärmeschrumpfbare Folienbasis auf Polyesterbasis wenigstens einen Copolyester enthält, der aus Copolyestern ausgewählt ist, die aus einer Dicarbonsäurekomponente, die wenigstens eine Dicarbonsäure wie Terephthalsäure, Oxalsäure, Malonsäure, Bernsteinsäure, Adipinsäure, Suberinsäure, Azelainsäure, Sebacinsäure, Phthalsäure, Isophthalsäure, Naphthalindicarbonsäure, Diphenylethercarbonsäure beinhaltet, und einer Diolkomponente, die wenigstens ein Diol wie Ethylenglykol, Neopentylglykol, Propylenglykol, Trimethylenglykol, Tetramethylenglykol, Hexamethylenglykol, Diethylenglykol, Polyalkylenglykol, 1,4-Cyclohexandimethanol beinhaltet, erhalten werden.

**9.** Metallisierte Folie auf Polyesterbasis nach Anspruch 8, wobei in dem Copolyester ein Anteil eines Terephthalsäuremonomers unter den Dicarbonsäuremonomeren 80 Mol% oder mehr beträgt und ein Anteil anderer Monomere mit Ausnahme von Ethylenglykol unter den Diolmonomeren 12 bis 24 Mol% beträgt.

**10.** Metallisierte Folie auf Polyesterbasis nach Anspruch 1, wobei die wärmeschrumpfbare Folienbasis auf Polyesterbasis eine uniaxial orientierte wärmeschrumpfbare Folienbasis auf Polyesterbasis oder eine biaxial orientierte wärmeschrumpfbare Folienbasis auf Polyesterbasis ist.

**11.** Metallisierte Folie auf Polyesterbasis nach Anspruch 1, wobei in dem Fall, in dem sie 10 Sekunden lang mit heißem Wasser bei 90 °C behandelt wird, ein Schrumpfungsverhältnis in der maximalen Schrumpfungsrichtung 40 bis 80 %, eine Schrumpfungseinleitungstemperatur in der maximalen Schrumpfungsrichtung 68 bis 94 °C, eine maximale Schrumpfungstemperatur 80 bis 110°C und eine maximale Schrumpfungsspannung 0,6 bis 1,80 mg/mm$^2$ beträgt.

**12.** Metallisierte Folie auf Polyesterbasis nach Anspruch 1, wobei sie eine Gesamtdurchlässigkeit von 0,01 bis 5 % aufweist.

**13.** Metallisierte Folie auf Polyesterbasis nach Anspruch 1, wobei die wärmeschrumpfbare Folienbasis auf Polyesterbasis eine Trübung von 0,3 bis 10 % aufweist.

**14.** Mit einem Etikett versehene Flasche, die die metallisierte Folie auf Polyesterbasis nach Anspruch 1] umfasst.

**15.** Mit einem Etikett versehene Flasche nach Anspruch 14, wobei die metallisierte Folie auf Polyesterbasis durch Eintauchen der Flasche in heißes Wasser entfernt wird.

**16.** Mit einem Etikett versehene Flasche, die die metallisierte Folie auf Polyesterbasis nach Anspruch 2 umfasst.

**17.** Mit einem Etikett versehene Flasche nach Anspruch 16, wobei die metallisierte Folie auf Polyesterbasis durch Eintauchen der Flasche in heißes Wasser entfernt wird.

## Revendications

**1.** Film de métallisation chimique à base de polyester comprenant :

une base de film à base de polyester thermorétractable ;
une couche de dépôt métallique formée sur la base ; et
une couche d'impression formée sur la couche de dépôt métallique et une couche arrière formée sur l'autre surface du film à base de polyester thermorétractable sous forme de couche de gaufrage formée par traitement physique ou chimique d'une surface du film à base de polyester thermorétractable ou d'une couche de revêtement de pigment blanc,
une rigidité du film dans une direction de rétrécissement maximale étant de 1,5 à 13 g/mm$^2$ (déterminée selon le procédé décrit ici), et une valeur caractéristique de recoquillement définie par une description détaillée étant de 5 mm ou moins.

**2.** Film de métallisation chimique à base de polyester selon la revendication 1, comprenant en outre une couche d'apprêt formée entre la couche de dépôt métallique et la couche d'impression.

**3.** Film de métallisation chimique à base de polyester selon la revendication 1, comprenant en outre une couche protectrice formée sur la couche d'impression,
la couche protectrice étant constituée indifféremment de copolyester, d'un copolymère acrylique, d'un copolymère de styrène, un copolymère de méthacrylate, de polystyrène, d'acétate de vinyle, de polyamide, d'alkylacrylate, d'urée-formaldéhyde, d'huile de soja époxydée, d'un copolymère d'acétate de vinyle-éthylène, d'oléamide à base de suif, de distéarate de polyéthylène glycol, de polyvinylidène, d'un copolymère à base de polyoléfine, d'une résine uréthane et d'une résine à base de vinyle, ou d'un mélange de ceux-ci.

**4.** Film de métallisation chimique à base de polyester selon la revendication 2, comprenant en outre une couche protectrice formée sur la couche d'impression,
la couche protectrice étant constituée de copolyester, d'un copolymère acrylique, d'un copolymère de styrène, un copolymère de méthacrylate, de polystyrène, d'acétate de vinyle, de polyamide, d'alkylacrylate, d'urée-formaldéhyde, d'huile de soja époxydée, d'un copolymère d'acétate de vinyle-éthylène, d'oléamide à base de suif, de distéarate de polyéthylène glycol, de polyvinylidène, d'un copolymère à base de polyoléfine, d'une résine uréthane et d'une résine à base de vinyle, ou d'un mélange de ceux-ci.

**5.** Film de métallisation chimique à base de polyester selon la revendication 1, la base de film à base de polyester thermorétractable présentant une épaisseur de 35 à 65 μm.

6. Film de métallisation chimique à base de polyester selon la revendication 1, la couche de dépôt métallique présentant une densité optique de 1,0 à 3,5.

7. Film de métallisation chimique à base de polyester selon la revendication 1, la base de film à base de polyester thermorétractable contenant une résine à base de polyester comportant un motif répété de butylène téréphtalate.

8. Film de métallisation chimique à base de polyester selon la revendication 1, dans lequel la base de film à base de polyester thermorétractable contient au moins un copolyester choisi parmi les copolyesters obtenus à partir d'un constituant acide dicarboxylique comportant au moins un acide dicarboxylique tel que l'acide téréphtalique, l'acide oxalique, l'acide malonique, l'acide succinique, l'acide hexanedioïque, l'acide subérique, l'acide azélaïque, l'acide sébacique, l'acide phtalique, l'acide isophtalique, l'acide naphtalène dicarboxylique, l'acide d'oxyde de diphényle carboxylique et un constituant à diol comportant au moins un diol tel que l'éthylène glycol, le néopentyle glycol, le propylène glycol, le triméthylène glycol, le tétraméthylène glycol, l'hexaméthylène glycol, le diéthylène glycol, le polyalkylène glycol, 1'1,4-cyclohexane diméthanol.

9. Film de métallisation chimique à base de polyester selon la revendication 8, dans lequel dans le copolyester, un rapport d'un monomère d'acide téréphtalique parmi les monomères d'acides dicarboxyliques représente 80 % en moles ou plus, et un rapport d'autres monomères à l'exception de l'éthylène glycol parmi les monomères de diols représente 12 à 24 % en moles.

10. Film de métallisation chimique à base de polyester selon la revendication 1, dans lequel la base de film à base de polyester thermorétractable est une base de film à base de polyester thermorétractable à orientation uniaxiale ou une base de film à base de polyester thermorétractable à orientation biaxiale.

11. Film de métallisation chimique à base de polyester selon la revendication 1, dans lequel, au cas où il est traité à l'eau chaude à 90 °C pendant 10 secondes, un taux de rétrécissement dans la direction de rétrécissement maximum est de 40 à 80 %, une température d'initiation du rétrécissement dans la direction de rétrécissement maximale est de 68 à 94 °C, une température de rétrécissement maximale est de 80 à 110 °C et une tension de rétrécissement maximale est de 0,6 à 1,80 kg/$mm^2$.

12. Film de métallisation chimique à base de polyester selon la revendication 1] présentant une transmission totale de 0,01 à 5 %.

13. Film de métallisation chimique à base de polyester selon la revendication 1, la base de film à base de polyester thermorétractable présentant un trouble de 0,3 à 10 %.

14. Etiquette fixée à une bouteille comprenant le film de métallisation chimique à base de polyester selon la revendication 1.

15. Etiquette fixée à la bouteille selon la revendication 14, le film de métallisation chimique à base de polyester étant retiré en plongeant la bouteille dans de l'eau chaude.

16. Etiquette fixée à une bouteille comprenant le film de métallisation chimique à base de polyester selon la revendication 2.

17. Etiquette fixée à la bouteille selon la revendication 16, le film de métallisation chimique à base de polyester étant retiré en plongeant la bouteille dans de l'eau chaude.

[DRAWINGS]

[FIG. 1]